(19)

Europäisches
Patentamt

European
Patent Office

Office européen
des brevets

(11)  **EP 3 015 872 B1**

(12)  **EUROPEAN PATENT SPECIFICATION**

(45) Date of publication and mention
of the grant of the patent:
**03.12.2025   Bulletin 2025/49**

(21) Application number: **14405077.0**

(22) Date of filing: **30.10.2014**

(51) International Patent Classification (IPC):
**G01R 19/165** (2006.01)     **H02H 3/24** (2006.01)
**H02H 3/20** (2006.01)     **H03K 5/1534** (2006.01)

(52) Cooperative Patent Classification (CPC):
**H02H 3/207**; G01R 19/16566; H03K 5/1534

(54) **Threshold detection circuit**

Schwellwertdetektionsschaltung

Circuit de détection de seuil

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**04.05.2016   Bulletin 2016/18**

(73) Proprietor: **Delta Electronics (Thailand) Public
Co., Ltd.
Samutprakarn 10280 (TH)**

(72) Inventor: **Krumpholz, Christian
79110 Freiburg (DE)**

(74) Representative: **Keller Schneider
Patent- und Markenanwälte AG
Eigerstrasse 2
Postfach
3000 Bern 14 (CH)**

(56) References cited:
**EP-A1- 0 284 279       JP-B1- 5 291 271
US-A- 5 019 722       US-A1- 2008 258 709
US-A1- 2015 263 604**

**Description**

**Technical Field**

The invention relates to a circuit arrangement, which comprises an AC-input port for connecting an AC line voltage and a threshold detection circuit for detecting a crossing of a first voltage threshold by the AC line voltage, where the AC-input port includes a first input terminal and a second input terminal and the threshold detection circuit includes a first voltage input, a first detection output and a first comparator element for comparing a voltage at the first voltage input to a reference voltage and for outputting a detection signal at the first detection output if said voltage at the first voltage input crosses said reference voltage, said circuit arrangement includes a band-pass filter connected between the AC-input port and said first voltage input.

**Background Art**

Supervision of AC voltage is required in a lot of modern electrical devices. The connected devices have to be protected and a safe switch-off has to be guaranteed at any AC voltage failure.

A well-known and generally accepted principle of a line-voltage sensing circuit consists in a one- or two-way rectifier, a simple voltage divider, any means of averaging, a reference circuit and a comparator. The rectified line voltage is for example scaled down by a voltage divider, averaged by a capacitor before being compared to a reference signal. A drawback of these circuit arrangements is that the averaging respectively the filtering of the dressed signal implies start-up and switch-off delays. Impedances in the DC-circuit may lead to imprecise voltage detection.

DE 197 48 633 A1 describes a method and a circuit arrangement for monitoring a defined amplitude threshold value of an AC-voltage. This circuit arrangement comprises a rectifier circuit, a voltage divider, a comparator circuit, a zero crossing detector and a timer. The comparator is connected via the voltage divider to the input. When the voltage amplitude of the AC voltage is above a predefined threshold, then the comparator output is true. Every time, when the AC voltage of a reference voltage of similar frequency and phase as the AC-voltage signal crosses the zero, a timer is started. The timer interval is chosen such that the comparator output is read, when the maximum voltage is present at the input lines. This circuit allows fast voltage threshold detection. However it requires additional components, e.g. a zero crossing detector, what makes the circuitry more complex und increases the power consumption. Also the timer has to be adjusted to the AC voltage frequency and the circuit arrangement is susceptible to noise in the line voltage.

JP H02292942 describes an AC-signal reception circuit directly connected to an AC-input line. The circuit comprises two bi-directional Transient Absorption Zener (TAZ) Diodes in series with a capacitor and a resistor. A photo coupler transmits a signal to a secondary circuit when the voltage exceeds the predefined threshold. The photo coupler consists in two anti-parallel diodes being connected in between the TAZ-diodes and a light reception photo transistor. The capacitor in the circuit cuts the DC part of the AC signal and decreases the power dissipation. Due to the use of bi-directional TAZ Diodes a single threshold level can be selected for both, negative and positive voltages. The circuit arrangement thus is also susceptible to noise.

JPH09145751 discloses a power failure detection circuit. It comprises a limiting circuit which is connected between the AC-input voltage. The limiting circuit comprises two opposed Zener diodes connected between their anodes. A photo coupler consisting of light emitting diodes being connected to the limiting circuit and light reception transistor transmits a signal when the AC threshold is exceeded. This circuit does not require any rectification unit, nor a voltage divider or a timing circuit. However it has significant continuous power consumption when a threshold is exceeded.

JP5291271 B1 discloses a power conversion device 1 of an electric vehicle with a transformer 2 followed by a AC/DC converter 3. An AC power is supplied to the primary side of the transformer 2 from an overhead wire 11 through a power collector 12. The AC power from the secondary side of the transformer 2 is supplied to an inverter 14 via an intermediate circuit that includes a filter capacitor 13. The inverter 14 converts the DC power into AC power that is used to drive an electric motor 15. The power conversion device 1 includes a voltage detector 8 that supplies the detected voltage to a converter controller 4 and a frequency detector 6 through a bandpass filter BPF 5. The converter controller 4 controls the switches of the converter 3 based on the detected AC overhead wire voltage. The frequency detector 6 detects a frequency of the overhead wire voltage based on an interval between time points at which the overhead wire voltage via the BPF 5 exceeds a threshold. A filter adjuster 7 adapts the bandpass filter 5 such that its centre frequency corresponds to the detected frequency of the AC overhead wire voltage.

**Summary of the invention**

It is the object of the invention to create a circuit arrangement for detection of a threshold crossing by an AC voltage pertaining to the technical field initially mentioned, that protects reliably electrical devices by fast and safe switch off at an AC voltage failure. The design should be simple and low cost. In addition it should minimize power consumption and therefore must be designed to be robust against perturbations while allowing a fast threshold detection. It is a further object of the invention to create an electrical device such as a power supply including such a circuit arrangement as well as a corresponding method.

The solution of the invention is specified by the features of claim 1 and method claim 16. According to the invention the circuit arrangement for detecting a crossing of a threshold by an AC line voltage according to the field mentioned above includes a band-pass filter connected between the AC-input port and said first voltage input.

By inserting a band-pass filter between the AC-input port and the first voltage input of the threshold detection circuit the device becomes robust, as it filters out spikes, bursts and surges very thoroughly, while the detection still operates fast, because no redressing and subsequent signal smoothing is necessary. Another advantage is that the invention allows monitoring of the AC voltage directly. There is no deformation or displacement of the monitored signals due to impedances like Y-caps in peripheral circuits, as it is often the case when the signal has to be redressed before feeding to a comparator circuit. Such impedances are frequently located behind a rectifier to protective earth in order to reduce electromagnetic interference. Moreover, the circuit arrangement according to the invention is simple and cost-efficient.

The filtered voltage is compared at the first signal input of the threshold detection circuit to a reference voltage by the comparator element which generates a low voltage or a high voltage signal at the detection output. The comparator element is preferably realized by a comparator circuit realized with an operational amplifier. In another embodiment the comparator is realized by means of a logic gate with a Schmitt-trigger input.

The reference voltage preferably is constant. In a particular embodiment it might be adjustable, time varying and in some cases even following a tracking signal.

Thus, the threshold might be adjusted to a specified network frequency or voltage or to compensate for variation of frequency and amplitude variations of the AC voltage. In some applications however it might be advantageous that the threshold can be continuously adapted.

Preferably the circuit arrangement is used for line voltage sensing of a main voltage. The voltage can be sensed between line (L) and neutral (N) or between line (L) and line (L). However it also can be used to sense any type of AC voltage, for instance the output voltage of a DC-AC converter or any other AC voltage source.

The circuit also comprises at least one output which can be used for further processing. In a preferred embodiment the output values are digital, especially binary output values. Typically, the binary output values are interpreted by a logical "1" or a logical "0". In another embodiment the output signals are analogue signals, for instance voltage pulse signals.

In another advantageous embodiment the band-pass filter provides a first output signal at a first filter output. The first output signal is scaled by a first scaling factor in relation to the AC line voltage. Further the first voltage input is connected to the first filter output.

Scaling means that the band-pass filter may comprise a substantially non-unity-gain in the pass-band, where the gain of the band-pass being defined by the quotient between the first output signal and the AC voltage.

By scaling the filter output signal in relation to the AC voltage, the output signal at the filter output can be adapted such, that low voltage components can be used for the threshold detection circuit. A further advantage of scaling the output signal is that the voltage threshold level at which a passing of the AC voltage has to be detected can be set by the choice of the scaling factor while a fix reference voltage can be used. Thus also standard reference voltage sources may be used.

The scaling factor also can be chosen equal or substantially equal to one, such that the gain of the filter is one or close to one in the pass-band. In this case the threshold levels can be adapted by modifying the reference voltage. A drawback of this embodiment is that the threshold detection circuit needs to be designed to support the entire AC voltage at the first signal input, which increases hard ware costs.

In some cases it might even be advantageous to amplify the input signal by the band-pass filter, for instance when detecting a threshold of a low voltage AC-input signal. This might for instance be the case if the AC-voltage to be monitored is of low voltage, being for instance tapped by a voltage probe head.

In a further preferred embodiment the band-pass filter comprises a second filter output that is scaled by a second scaling factor in relation to the AC line voltage and the threshold detection circuit is adapted to detect a crossing of a second voltage threshold by the AC line voltage. Therefore the threshold detection circuit includes a second voltage input connected to the second filter output. The threshold detection circuit further includes a second detection output and a second comparator element for comparing a voltage at the second voltage input to the above mentioned reference voltage or to a second reference voltage.

By providing means to detect the passing of a second threshold manifold opportunities for the subsequent processing arise. One important advantage is that it allows ensuring a hysteretic behaviour of the circuit when combining the circuit with a logic circuit for evaluation of the detection signals. The hysteretic behaviour can be achieved by choosing a higher threshold and a lower threshold, both thresholds defining a certain tolerance of the amplitude of the AC voltage. For instance, a higher threshold has to be passed to activate an output signal. The output signal is only deactivated when the AC voltage does not pass the lower threshold for a duration of at least one signal period. This may render the voltage detection much more robust in presence of variations of the amplitude of the AC voltage. Causes of such variations may be caused by amplitude modulations of the main supply itself but also by other effects as for instance, temperature bound variations of electrical of components of the circuit arrangement or other peripheral components. Providing a second scaled filter output allows the scaling of the second output signal such the threshold detection circuit may comprise one single reference voltage for comparing the voltage at the first and the second voltage input, though the passing of two different voltage level might be detected. The first and the second output signal are preferably in phase, which means that the transfer functions of the band-pass filter between the AC input voltage and the filter output signals are only differed in gain. However, in some cases it might be advantageous that the filter has two different transfer functions which could for instance enlarge the frequency range of circuit arrangement. The first and the second scaling factor might however also be equal. In this case different threshold levels for detecting the passings of the AC voltage can be set by means of a different first and second reference voltage.

The threshold passings to be detected can be both positive or negative (unipolar thresholds) or be of opposite signs (bipolar thresholds). In a preferred embodiment of the invention, a passing of a positive or a negative half-wave of the AC voltage input voltage can be detected, such that the circuit can react faster after one half AC voltage cycle instead of two AC voltage cycles in case of unipolar thresholds.

According to another advantageous embodiment of the invention the pass-band of said band-pass filter includes a fundamental frequency range of the AC line voltage. A phase shift of the band-pass filter in the fundamental frequency range is below 45° and a gain difference in regard to the respective scaling factors is less than 0.5 dB. The fundamental frequency range is preferably between 45Hz and 65Hz, the phase shift preferably being below 5°, the gain difference preferably being less than 0.1 dB and said band-pass filter preferably comprising a second order band-pass filter.

By designing the band-pass filter such that the pass-band includes the supported fundamental frequency range, having a flat frequency response in this area, the circuit arrangement can detect threshold passing for the entire supported fundamental frequency range. The criteria on the gain difference derive mainly from the tolerance of the threshold passings in the whole fundamental frequency range while the allowable phase shift of +/-45° is a requirement for an efficient design of the threshold detection circuit.

With said gain difference of +/-0.5 dB the variation of the threshold level is less than +/-6% over the entire supported frequency range. A smaller difference of +/- 0.1 dB is preferred, which decreases the error to +/- 1.2 % in the entire supported frequency range, such that the same circuit arrangement may be used independently of the line voltage frequency in different countries. In a further preferred embodiment the phase shift in the fundamental frequency range is less than +/- 5 degrees, which further facilitates the hardware design and reduced the maximum response time of the detection circuit.

Most public power networks have a nominal fundamental frequency between 50 Hz and 60 Hz. Due to network variations fundamental frequencies may vary in a range of +/- 5 Hz. In a preferred embodiment of the invention the band-pass therefore includes a fundamental frequency range between 45 and 65 Hz.

In a further advantageous embodiment, the band pass filter is of 2nd-order. The advantage of this embodiment is, that it is very easy to implement and cost-efficient as it can be built by two single RC-circuits. However it also is possible to implement filter of higher order or to use digital filters.

The flat behaviour in the fundamental frequency range can for instance be achieved by a second order band-pass filter with a first -3dB cut-off frequency of a lower stop-band at around 5Hz and a second -3dB cut-off frequency of a higher stop-band at 600Hz.

In an alternative embodiment the band-pass of the band-pass filter includes the fundamental frequency, however the frequency range of the pass-band being very narrow. In this case the band-pass filter may filter out very efficiently noise with frequencies different from the fundamental frequency of the line voltage; however this circuit arrangement may work only for a certain fundamental frequency or requires tuning the filter.

In a further preferred embodiment the band- band-pass filter comprises a first serial RC circuit and a second serial RC circuit. Here a capacitor of the first serial RC circuit is coupled to a first terminal of the AC input port and a resistor of the first serial RC circuit to a second terminal of the AC input port, while a capacitor of the second serial RC circuit is coupled to a tap between the capacitor and the resistor of the first serial RC circuit and a resistor of the second serial RC circuit to the first input terminal of the AC input port. In addition each of the filter outputs is connected to a tap between the resistor of the second serial RC circuit or to a tap between said resistor and the capacitor of the second RC circuit.

The advantage of this embodiment of a band-pass filter is that it is very simple to implement, very robust and cost efficient. The first serial RC is connected between the terminals of the AC input port and acts as low-pass filter defining the higher cut-off frequency of the pass-band while the second RC circuit, being connected with the capacitor to the first RC circuit and with the resistor to an input port of the AC input port, in parallel to the capacitor of the first RC circuit, defines the lower cut-off frequency of the band-pass filter. The advantage is that the resistor of the second RC circuit may be split up to a voltage divider, such that a precise scaling of the output voltage is easy to realise. Alternatively the first RC circuit could define the lower cut-off frequency of the pass-band and the second RC filter the higher cut-off frequency, by swapping resistors and capacitors of the RC-circuits. In this embodiment a capacitive voltage divider would replace the resistive voltage divider of the above mentioned preferred embodiment. The disadvantage of a capacitive voltage divider is that it is less precise than a resistive voltage divider.

It is possible to connect more than two outputs to the voltage divider in order to define more than two thresholds.

In a further advantageous embodiment of the invention the first output signal of the band-pass filter is defined by its voltage potential in reference to the first input terminal and the second output signal of the band-pass filter by its voltage potential in reference to the second terminal. By defining the first output signal in reference to the first input terminal while defining the second output signal in reference the second input terminal, a symmetrical circuit layout, can be achieved which involves different advantages. In particular the circuit will work bipolar allowing detecting positive and negative thresholds equally effective.

In an additional preferred embodiment the first and the second output signal of the band-pass filter are defined by their voltage potential in reference to the first input terminal of the AC input port. This unipolar embodiment of the invention may be advantageous if only positive thresholds (or negative thresholds) may be detected. In the unipolar embodiment fewer components are required which decreases power consumption and costs.

In a further preferred embodiment of the invention the band-pass filter comprises a first serial RC circuit, a second serial RC circuit and a third serial RC circuit. In this embodiment the first serial RC circuit includes a first capacitor being coupled with one terminal to the first input terminal of the AC input port, a second capacitor being coupled with one terminal to the second input terminal of the AC input port and a resistor being coupled between the free terminals of the above mentioned first and second capacitor. Furthermore, a capacitor of the second serial RC circuit is coupled to a tap between the resistor and the first capacitor of the first serial RC circuit while a resistor of the second serial RC circuit is connected to the first input terminal of the AC input port.

In this preferred embodiment the first filter output is connected to a tap between the resistors of the second serial RC circuit or a tap between the resistor and the capacitor of said second serial RC circuit. Moreover, a capacitor of the third serial RC circuit is coupled to a tap between the resistor and the second capacitor of the above mentioned first serial RC circuit, while a resistor of the third serial RC circuit is connected to the second input terminal of said AC input terminal. Finally, the second filter output is connected to a tap between the resistor of said third serial RC circuit or to a tap between the resistor and the capacitor of said third serial RC circuit.

An advantage of this embodiment is that it is totally symmetrical. The first serial RC circuit is defining the higher cut-off frequency of the pass-band filter and therefor acting as low pass filter while the second and third RC filter define the lower cut-off frequency of the pass band filter and are acting as high-pass filters. The resistors of the second and third serial RC circuit may split up to form a first and a second voltage divider, for providing the first und the second output signal of the band-pass filter and therefore for scaling the output signals. Different scaling factors for the first and the second output signal can be easily defined by the voltage dividers, which means that different thresholds can be easily defined for positive and negative half waves of the AC voltage signal.

In an alternative embodiment the first serial RC circuit defines the lower cut-off frequency of the band-pass filter, such as acting as high-pass filter while the second serial RC circuit and the third RC circuit are defining the higher cut-off frequency of the pass-band, such acting as low-pass filter. In reference to the above mentioned embodiment capacitors and resistors are swapped. At the first and the second output a first and a second capacitive voltage divider may allow defining the first and the scaling factor of the band-pass filter. The disadvantage of this embodiment is that a capacitive voltage divider is less precise than a resistive voltage divider.

In another advantageous embodiment of the invention the threshold detection circuit comprises a first blocking element preferably a diode, being connected between the first voltage input of the threshold detection circuit and the first terminal of the AC-input port.

In a particular embodiment the threshold detection circuit comprises a second blocking element if the second filter output signal is defined by its voltage potential in reference to the second input terminal of the AC-input port. In both embodiments the blocking elements are conducting in the direction from the adjacent input terminal to the respective first voltage input and blocking in the opposite direction.

The blocking element protects the subsequent elements of the threshold detection logic as it limits the negative voltages applied at the first input of the threshold detection logic. If the threshold detection circuit has two inputs and the second filter output signal is defined in reference to the first input terminal of the AC voltage, a second blocking element at the second voltage input of the threshold detection circuit may be redundant. If the second output signal of the band-pass filter is defined by its voltage potential in reference to the second input terminal of the AC-input port, the second blocking being connected between the second voltage input and the second input terminal of the AC input port also protects subsequent comparator elements, in particular operational amplifiers from detrimental negative voltages. The blocking elements a preferably realised by diodes but also other components, for instance controllable switches, may be used which limit the voltage in negative direction.

Alternatively the blocking elements may be omitted, implying that the whole negative voltage is applied the input of the comparator element. This signifies that the comparator elements have to support the applied negative voltages or that another protecting circuit has been used instead of the blocking element. In some cases a small scaling factor might be chosen such that negative voltage is kept small enough.

One could also use comparator circuits based on Zener diodes, supporting high voltages.

Beside diodes also active components as for instance MOSFETs could be used to protect the comparator elements against significant negative voltages.

In a further preferred embodiment of the invention each comparator element provides hysteresis. The comparator element can be built up by means of a comparator circuit, for instance a circuit using an operational amplifier, with positive feedback in order to provide hysteresis, but it can also be realized by using a logic gate with a Schmitt-Trigger input or any other circuit providing positive feedback. The advantage of providing hysteresis is that the comparator output is switching faster which makes the realisation of the subsequent circuit respectively of the output drivers easier. Through the hysteresis also the presence of noise can be suppressed. In an alternative embodiment the comparator element may not provide hysteresis. This may render the circuit simpler and faster, but more sensitive to noise.

In an additional preferred embodiment each reference voltage is provided by a respective reference voltage circuit which includes an adjustable Zener shunt regulator. The advantage of this embodiment is that a precise reference voltage can be generated in reference to the AC input terminal. The integration also reduces the complexity of the circuit arrangement and costs. By using adjustable Zener shunt regulators also the power consumption can be reduced and the reference voltage may be adjusted. Alternatively a conventional Zener shunt regulator may be used to provide the reference voltage. A conventional Zener shunt regulator however usually generates a less precise reference voltage, has a higher power consumption and its output voltage cannot be adjusted.

A further advantageous embodiment of the invention comprises a DC supplying circuit for supplying a first DC supply voltage to the threshold detection circuit. The DC supplying circuit allows the use of active components requiring a DC supply voltage while simplifying the design of the threshold detection circuit

It can also generate the DC supply voltage for supplying the reference voltage circuit or may even supply directly the first reference voltage.

Preferably, the DC supplying circuit is powered by the AC voltage connected to the first and second input terminal. Thus this embodiment makes the circuit arrangement less complex and more robust.

The DC supplying circuit however could also be powered by another energy source, as for instance a battery or a solar cell.

The use of an external DC supply voltage for the active components is also possible, but would significantly increase the complexity of the circuit, costs and power consumption unless such an additional power supply is provided anyway.

Advantageously said DC supplying circuit comprises a first DC charging circuit for generating a first DC supply voltage Vcc1 in reference to the first input terminal of the AC input port and a capacitive element. The DC charging circuit and the capacitive element are connected in series between the first and second input terminal of the AC input port. Herein the capacitive element acts as load for limiting the current and the voltage. The DC charging circuit comprises a parallel circuit which includes a capacitor which is charged by the AC voltage and a voltage limiting element for limiting the DC supply voltage of the DC charging circuit. The limiting element preferably is a Zener diode.

The AC voltage present at the AC input terminals is used to charge the capacitor of the charging circuit until a desired DC supply voltage is reached. The DC supply voltage can be defined by the rating of a voltage limiting element in the charging circuit. In particular a Zener diode can be used as limiting element, but also other limiting circuits may be used. The capacitive element acts as load to limit the current flow and the voltage which is applied to the DC charging circuit. As reactive element it has the advantage that it implies only small losses compared to a resistive element which also could be used.

In a further preferred embodiment said capacitive element is connected with a first terminal to the second terminal of the AC-input port and the first DC charging circuit includes a first and a second terminal and a parallel circuit with a first and a second leg. The first terminal of the first DC charging circuit is connected to the first terminal of the AC-input port and the second terminal of the first DC charging circuit to a second terminal of the capacitive element. Said first leg comprises a first diode connected in series to a parallel circuit including a Zener diode and a capacitor, an anode of said Zener diode is connected to the first input terminal of the first DC charging circuit. A cathode of the Zener diode is connected to a cathode of said first diode while the anode of said first diode is connected to the second input terminal of said first DC charging circuit. The second leg comprises a second diode, wherein an anode of the second diode is connected to the first input terminal of the first DC charging circuit and a cathode of the second diode to the second input terminal of the first DC charging circuit.

Alternatively also other energy storing elements than capacitive elements could be used to store the energy produced by the AC voltage and to provide the DC supply voltage.

One might alternatively store the energy by means of an rechargeable accumulator element or also by an inductive element, both being charged or energized by the AC voltage. It is also thinkable to use different storage elements in combination.

The advantage of capacitive elements is however that they are very robust, cheap and easy to integrate.

In another further preferred embodiment the DC supplying circuit comprises a second DC charging circuit which is similar to the first charging circuit. The first charging circuit; the second charging circuit and the capacitive element are arranged in a mirror symmetrical manner in regard to the first and the second input terminal of the AC input port for providing a first DC supply voltage Vcc1 and a second DC supply voltage Vcc2 to the threshold detection circuit.

The first DC charging circuit is connected with its first terminal to the first input terminal of the AC input port, the second charging circuit is connected with its first terminal to the second input terminal of the AC input port. The capacitive element is connected with its terminals to the second input terminals of the first and the second DC charging circuit.

The topology of this embodiment of the DC supplying circuit is totally symmetrical. It uses the design of a modified bridge rectifier with the capacitive element as load. The symmetry of the circuit has commercial benefits and optimizes power consumption.

Alternatively, also in this embodiment, the capacitive element also could be replaced be a resistive element.

In an additional preferred embodiment exactly one controllable switch is assigned to each of the detection outputs, the controllable switch comprising a first and a second terminal and a control input. The control input is connected to respective detection output of the threshold detection circuit and the first terminal to one of the two input terminals of the AC-input port to which the corresponding filter output signal is referenced and the second terminal to another one of the two input terminals of the AC-input port. The controllable switches are always conducting from the first terminal to the second terminal, the controllable switches preferably comprising a MOSFET with a source connected to the first terminal of said controllable switch, a drain connected to the second terminal of said controllable switch, a gate connected to the control input of said controllable switch.

The controllable switch may function as means to actuate a device, for instance as a means of switching off or on a device. The controllable switch may also generate a signal which is used for further processing. The controllable switch is closed respectively conducting when the respective control input is activated and opened respectively deactivated or blocking otherwise. When a voltage is applied between the first and second input terminal of the activated controllable switch, a current flow through the switch will result. In this case the fact that a current flow carries the binary information that a threshold has been detected. In addition, if the sign of the voltage present at the terminals of the switch corresponds to the sign of the AC input voltage, the direction of the current may contain the information of the sign of the threshold value. As power is consumed only as long as current flow through the switch and a voltage is present between the first and the second terminal of the switch, the power consumption is limited to the time when the control input is activated. By limiting the time, the control input is activated after the threshold has been detected the power consumption can be reduced. This condition is met by means of the capacitive element in the transfer circuit. The power consumption can be further reduced by limiting the current flow through the first and the second terminal of the switch.

In another embodiment the outputs include controllable electrical switches which are opened respectively blocking when the respective control inputs are activated and closed respectively conducting otherwise.

In another embodiment the switches control a voltage which carries the binary information that a threshold has been detected. Two controllable electrical switches are for instance connected to build a half bridge with two switches connected in series between the AC input terminals. The controllable electrical switches can be opened respectively closed by means of the control inputs. The voltage can be tapped in between the two switches.

In a further embodiment the outputs are realised by controllable optical switches. Depending on the control input the switch might either let pass or block a light beam which represents the binary information. The advantage of the embodiment is that there is no galvanic coupling between the detection circuit and the unit which does the further processing.

The binary output signal of the controllable switches can be used for further processing, e.g. for switching power stages on or off. This processing can be done by any logic circuit or any electronic device, e.g. a micro-processor. This allows easily integrating the circuit in numerous different devices.

It would however also be possible to use the binary signal of the output switches to directly control the electrical device, for example to switch it ON or OFF.

There are numerous advantages of the use of a MOSFET. One of the most important is that it is easy to control the MOSFET by a voltage based control input signal. They are also very cost effective in regard to their performance. Especially MOSFET can be operated with low power consumption.

In another preferred embodiment a Zener protected MOSFET is used, where a back-to-back Zener diode is integrated in the MOSFET device, connecting the gate and the source of the MOSFET, to protect the MOSFET from overvoltage.

In an alternative embodiment the controllable switch comprises a bipolar-junction transistor. This embodiment allows a lower driving voltage at the input terminal; a drawback is that the driving circuit for the control input is more complicated und the power consumption may be increased.

The circuit arrangement according to the invention comprises a threshold detection logic which includes a signal input per detection output and where each signal input is connected to a detection output for receiving respective detection signals. The threshold detection logic is adapted to generate control signals for enabling or disabling components of an electrical device, preferably an AC-DC power supply, based on the detection signals received at the signal inputs.

By means of the logic circuit an intelligent monitoring of the input voltage is possible. Usually the amplitude of the monitored AC voltage is apt to vary within a specified range around a specified value. The voltage detection circuit arrangement should therefore be working reliably in that specified range. For instance it might be allowable, that an overvoltage or an undervoltage is crossed for a limited time interval. Therefore the threshold detection logic might comprise a timer function which is started when a threshold has been passed by the AC voltage.

It also might be allowable that the amplitude of the AC input voltage may be submitted to limited long term variations, where the threshold detection logic should not trigger any reaction. The logic detection device might therefore preferable include a hysteretic function. Especially when the voltage amplitude of the input signal is close to a limit, the hysteretic function prevents flickering of the detection logic output signal.

Also after start up, when the required voltage has been detected and a device has consequently been switched on by means of a threshold detection circuit output signal, a load current will result. This load current might cause a voltage drop on the AC input line. In this case a hysteresis in the threshold detection circuit will decrease the effective voltage threshold and prevent an erroneous reaction of the threshold detection logic.

Preferably the behaviour of the detection logic might be adjustable so that the device can be used even if some of the environmental conditions change. For instance the supply frequencies of the power networks differ from country to country. A preferred version of the detection logic therefore provides for different cycle periods of the AC input voltage adaption means of the timer circuits of the threshold detection logic.

Further the tolerances of the AC input voltage or the connected device may be varying from network to network or also over time. By providing an adaption means for the threshold hysteresis, the detection circuit can be optimized for specific conditions.

Another implementation provides some auto learning or auto-tuning capability. This allows for instance to automatically compensate for long-term variations of the network or for auto adapting the threshold detection logic to the AC input voltage. The threshold detection logic might also be capable to measure the AC voltage frequency by - for instance - measuring the time between two consecutive threshold crossings.

In a further realisation the threshold detection logic will control other devices in case of power failure. It might disable devices, but also enable devices if adequate for environmental reasons like power saving or avoidance of acoustic or electromagnetic noise and heat development, for protection of devices and also for safety functions.

A control output also might be used as breaking signal for an electrical, a mechanical or an electromechanical device or for retraction of at least one axis in a device to a safe position. Thus the threshold detection logic provides safety functions.

The threshold detection logic might switch on or off devices for saving energy. Depending on the threshold level reached a different number of devices may be activated or deactivated. In this context activating means that the devices might be switched on or off or also put in an intermediate state as for instance a low energy, a standby or a sleeping mode.

Alternatively also an external threshold detection logic might be used. This might be interesting if for instance a central control unit is used which integrates the logical functions.

The circuit arrangement comprises a galvanically decoupling signal transfer circuit for transmitting the respective detection signals to the threshold detection logic. The galvanically decoupling transfer circuit comprises a galvanic decoupling element such as for example an optocoupler. In some applications the decoupling element however may also comprise an inductive element, as for instance a transformer, a capacitive element, a wireless transmission system, or some other decoupling element.

The transferred signals preferably are pulses as they are easier to be transferred over a galvanically decoupled interface.

The transferred signal itself can be just a high-low (digital) signal or any modulated signal, for instance a pulse width, amplitude, frequency or phase modulated signal.

In an alternative embodiment of the invention the signal outputs may directly be outputted. The detection signals may directly be used to control at least one switch which for example directly switches on and off an electrical device that is energised by means of the AC input voltage.

On the other hand, if the detection signals are referenced to the AC Input voltage, the inputs to a subsequent control circuit or actuator preferably should be potential free. That implies that the subsequent control logic or actuator connected to the threshold detection circuit has to be provided with galvanically decoupling means.

Advantageously said signal transfer circuit includes in series connection a serial RC circuit, at least one of the controllable switches, a decoupling transfer circuit comprising a first LED and a diode that is arranged antiparallel to the first LED, said LED being conducting in the direction opposite to the direction in which the controllable switch is always conducting. The signal transfer circuit further includes a first light sensitive element for receiving light emitted by said first LED where the light sensitive element preferably includes a photo transistor.

The serial RC circuit is acting as differentiating element. The signal transfer circuit is connected between the first and the second terminal of the AC input port. When the polarity of the AC voltage is such that the first LED is in conducting state, but below the threshold, respectively the voltage at the connected detection output being low, the controllable switch is in blocking state and takes the whole input voltage.

However, when the half wave of the AC input voltage reaches the threshold value, the driving input of the closed switch shortly going from low to high, there will be a current flow through the resistor and the first LED until the capacitor of the RC circuit is charged. So there is only an impulse like current which promises low power consumption. Thus after triggering one of the controllable switches by means of the input terminal only a short impulse-like current passes the circuit, just enough to activate the LED as transmitting element. The light emitted by the LED may be received by a circuit comprising an optical element, for instance a photo transistor.

In addition, before the switching event the capacitive element has been loaded from the precedent AC voltage cycle of inverse polarity which helps to increase the current impulse. The advantage of this circuit is optimized power consumption while having a very simple design.

The RC circuit also might be replaced by a simple resistive element. The advantage is an even simpler design while increasing the power consumption of the circuit. Preferably the LED and the phototransistor are part of a photocoupler circuit.

This embodiment provides a galvanic decoupling between the threshold detection circuit and the threshold detection logic. The signal transfer circuit may comprise a serial connection including a serial RC circuit, a controllable switch and a decoupling transfer circuit for each detection output, wherein said connection may be arranged in parallel.

In a further embodiment of the invention a capacitive element is used as decoupling element in the decoupling transfer circuit. The circuit arrangement then comprises a serial RC circuit and a capacitive decoupling element connecting in serial with the controllable switch. A first capacitive decoupling element is connected to the second terminal of the first controllable switch. When the AC voltage reaches a threshold value, the switch goes from blocking to conducting state, therefore the voltage drop over the switch will break down, yielding to an abrupt voltage change on the second terminal of the toggling switch. The coupling capacitor will transmit the abrupt voltage change to the detection logic. There will be a current flow through the resistor until the capacitor of the serial RC circuit is charged. This embodiment also allows a very simple and energy efficient design while it is still galvanically decoupling the threshold detection circuit from the receiver circuit of the outputted signals.

In another embodiment the decoupling transfer circuit comprises a first capacitive element for transmitting the first threshold detection output signal. Said capacitive element is connected with one end to the first detection output, with the other end to the threshold detection logic. The capacitive element transmits impulse like voltage signals when a threshold crossing has been detected. Those analogue signals can be transformed to binary signals by different means. Examples are Schmitt-Triggers, electrical switches and comparator circuits.

Also with this embodiment it is possible to detect the thresholds of the positive and the negative half wave separately.

A further example of the transmitting element includes a transformer as transmitting element. The primary winding of the transformer is connected in series with the RC circuit. The peak-like current flow after the detection of a threshold induces a voltage in the primary and the secondary winding of the transformer. The polarity of the induced voltage also allows distinguishing the thresholds of the positive and the negative half wave of the AC input signal. An advantage of this embodiment is that the output voltage can be adapted by modifying the winding numbers of the transformer. The drawbacks of the transformer as coupling element are a bigger footprint and higher costs of the transformer.

A particular embodiment of the signal transfer circuit includes two controllable switches, a serial RC circuit connected in series to a parallel LED circuit, which comprises a first LED and a second LED that are arranged antiparallel to each other. The serial RC circuit and the parallel LED circuit are connected in series between the second terminals of said controllable switches. A first signal output of the transfer circuit includes a first light sensitive element for receiving light emitted by the first LED and a second signal output of the transfer circuit includes a second light sensitive element for receiving light emitted by said second LED, where each light sensitive element preferably includes a photo transistor.

Again, the RC circuit is acting as differentiating element. When the AC input voltage is below the threshold, always one of the switches is in blocking state and takes the whole input voltage. However, when a half wave of the AC input voltage reaches the threshold value, the driving input of the closed switch shortly going from low to high, there will be a current flow through the resistor and the one of the anti-parallel LEDs which is conducting in the direction of the current flow, until the capacitor of the RC circuit is charged. So there is only an impulse like current which promises low power consumption. Thus after triggering one of the controllable switches by means of the input terminal only a short impulse-like current passes the circuit, just enough to activate the LED as transmitting element. The light emitted by the LED may be received by a circuit comprising an optical element, for instance a photo transistor.

In addition, before the switching event the capacitive element has been loaded from the precedent AC voltage cycle of inverse polarity which helps to increase the current impulse.

The advantage of this circuit is optimized power consumption while having a very simple design.

The RC circuit also might be replaced by a simple resistive element. The advantage is an even simpler design while increasing the power consumption of the circuit.

This embodiment also provides a galvanic decoupling between the threshold detection circuit and the threshold detection logic. The two antiparallel diodes allow detecting thresholds of the positive and the negative half wave separately and therefore also to distinguish different threshold levels. Preferably the LED and the phototransistor are part of a photocoupler circuit. Alternatively also capacitive elements or inductive elements can be used to galvanically decouple the threshold detection logic from the threshold detection circuit.

In a preferred embodiment of such an electrical device, the circuit arrangement is used to sense the AC voltage and to switch the electrical device off if the input voltage is too low and to switch the device on if the input voltage is in an acceptable range.

This electrical device inherits all of the advantages of the circuit arrangement mentioned above.

The simple and low cost circuit arrangement allows a fast and reliable threshold detection by economizing power consumption.

In this context upstream and downstream are defined relative to the rectification unit. Upstream is the circuitry between the AC input terminals and the rectifier unit while downstream is everything on the other side of the rectifier. The transfer circuit transfers the detection signals from the threshold detection circuit to the threshold detection logic. The signals upstream of the rectifier are referenced to the AC voltage of the first and/or second input terminal, while the signals of the threshold detection logic are referenced to a negative potential of the threshold detection logic. This transfer has therefore to be potential free. It is an advantage of this embodiment, that the AC voltage is sensed upstream of the rectifier. First, the circuit is very robust against any disturbances, as no high resistance voltage divider is necessary to tap the AC input voltage, the threshold detection circuit being directly connected to the AC voltage input. For the same reason, the detection is not influenced by any impedances connected to the input or output lines, e.g. filtering Y-caps. Usually they are placed downstream of the rectifier needed for decoupling electromagnetic interference in the DC path. Second, the threshold passing off the AC line input voltage can be detected very reliable and fast, as there is no need to rectify and smooth the signal. A voltage threshold can be detected within half a period of the AC voltage signal in the case of a bipolar threshold detection circuit is used, within an entire period if an unipolar threshold detection circuit is used.

Alternatively the threshold detection circuit and the threshold detection logic might be arranged downstream of the rectifier unit. The advantage is that no galvanically decoupling might be necessary and the circuit arrangement will become simpler. However the circuit arrangement would become more sensitive to impedances connected to the output lines of the device. Also the response time may increase.

It even might be possible to arrange both, the threshold detection circuit and the threshold detection logic upstream of the rectifier. Also here no galvanically decoupling between the threshold detection circuit and the threshold detection logic might be necessary. But the design of the threshold detection logic would become more complex and also the output signals of the threshold detection logic are likely to have to be galvanically decoupled.

The invention also relates to a method for detecting a crossing of a threshold by an AC line voltage of a power network for an electrical device including components, the AC line voltage having a fundamental frequency of 45 Hz to 65 Hz, comprising the steps o

a. outputting a detection signal if a first voltage threshold if crossed by the AC line voltage,
b. providing a first input voltage by band-pass filtering the AC line voltage,
c. comparing a first input voltage to a reference voltage,
d. generating the detection signal if said first input voltage crosses said reference voltage,
characterized by the steps of
e. transmitting the detection signal with a galvanically decoupling transfer circuit to a threshold detection logic, and
f. generating control signals for enabling or disabling components of the electrical device with the threshold detection logic, based on the transmitted detection signal.

Other advantageous embodiments and combinations of features come out from the detailed description below and the totality of the claims.

**Brief description of the drawings**

The drawings used to explain the embodiments show:

Fig. 1    A schematic wiring diagram of a prior art voltage detection circuit;

Fig. 2    a schematic block diagram of an embodiment of an electrical device according to the invention;

Fig. 3a    a schematic block diagram of a first preferred embodiment of a circuit arrangement for detecting a crossing of a threshold by an AC voltage according to the invention;

Fig. 3b      a schematic wiring diagram of a threshold detection circuit according to the first preferred embodiment of the invention;

Fig. 4a      a schematic block diagram of the circuit arrangement for detecting a crossing of a threshold by an AC voltage according to a second preferred embodiment of invention;

Fig. 4b      a circuit diagram of an unipolar realisation of a band-pass filter according to the second embodiment of the invention;

Fig. 4c      a bode plot of the band-pass filter frequency response according to the second embodiment of the invention;

Fig. 4d      a circuit diagram of the threshold detection circuit according to the second embodiment of the invention;

Fig. 4e      an illustrative example of a circuit diagram of an unipolar transfer circuit according to the second embodiment of the invention;

Fig. 4f      an illustrative signal sequence for an exemplary AC input signal according to the second embodiment of the invention;

Fig. 5a      a schematic block diagram of a third preferred embodiment of a circuit arrangement for detecting a crossing of a threshold by an AC voltage according to the invention;

Fig. 5b      an illustrative signal diagram depicting an exemplary AC voltage and the corresponding output signal of the circuit arrangement according to the third embodiment of the invention;

Fig. 5c      a circuit diagram of a bipolar realisation of a band-pass filter according to the third embodiment of the invention;

Fig. 5d      a circuit diagram of a comparator circuit according to the third embodiment of the invention;

Fig. 5e      an illustrative example of a circuit diagram of a bipolar transfer circuit according to the third embodiment of the invention;

Fig. 6a      a circuit diagram of the bipolar version of the DC supplying circuit; according to the third embodiment of the invention;

Fig. 6b      a circuit diagram of the unipolar version of the DC supplying circuit, according to the first and second embodiment of the invention;

Fig. 6c      an illustrative signal plot of a charging cycle of the DC supplying circuit according to the invention;

Fig. 7      a schematic diagram of a threshold detection logic of a circuit arrangement according to the second and third embodiment of the invention;

Fig. 8      a circuit diagram of an alternative embodiment of the threshold detection circuit;

Fig. 9      a circuit diagram of an alternative embodiment of the circuit arrangement for detecting a threshold crossing.

In the figures, the same components are given the same reference symbols.

## Preferred embodiments

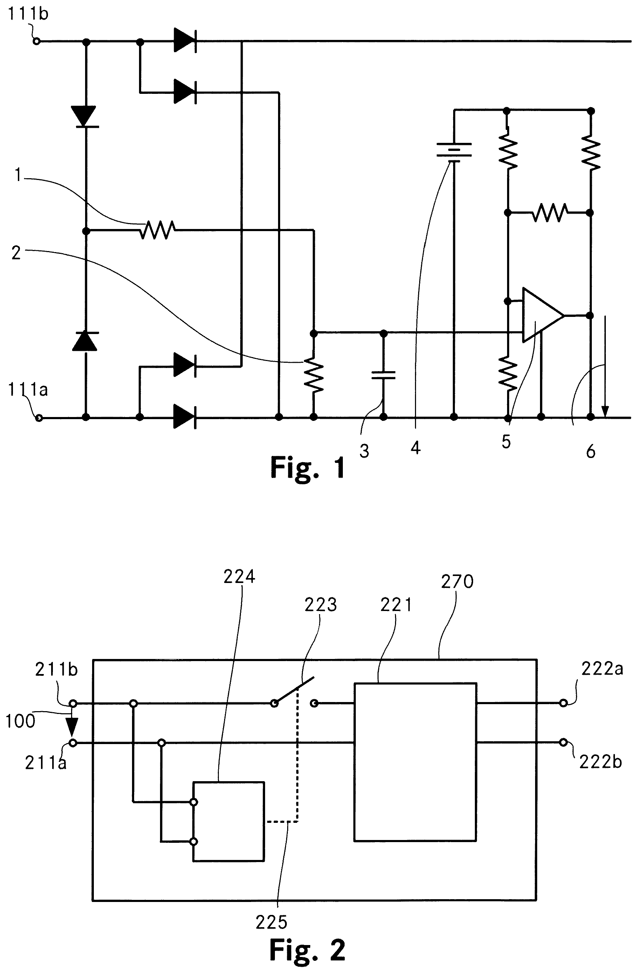

Fig. 1 shows a schematic wiring diagram of a voltage detection circuit according to the state of the art. A well-known and generally accepted principle of a line-voltage sensing circuit consists in a one- or two-way rectifier, a simple voltage divider, any means of averaging, a reference circuit and a comparator. The function of the circuit is as follows: The rectified line voltage between AC-input lines 111a and 111b is divided by resistors 1, 2, averaged by the averaging capacitor 3 and compared against the reference 4 by the comparator 5. The switching thresholds are defined by all resistors of the circuit. The output voltage 6 of the comparator 5 is either high or low. It can be used for further processing, e.g. switching power-stages on and off. A drawback of these circuit arrangements is that the averaging respectively the filtering of the dressed signal implies start-up and switch-off delays. Another disadvantage is that the resistive divider 1, 2 is high-resistive and if capacitive elements are placed downstream of the rectifier - usually needed for decoupling electromagnetic interference - the switching threshold will be false.

Fig. 2 shows a schematic block diagram of an embodiment of an electrical device 270 according to the invention.

The electrical device 270 according to Fig. 2 is for example an AC to DC converter which comprises a functional unit 221 such as for example a converter stage comprising a rectifier stage for converting the AC voltage 100 applied to input terminals 211a, 211b to a rectified DC-link voltage and an output unit for converting the DC-Link voltage to a DC output voltage provided at output terminals 222a, 222b.

In at least one of the lines from the input terminals 211a, 211b to the functional unit 221 a switch 223 is arranged to connect or disconnect the functional unit 221 from the respective input terminals 211a, 211b.

Further, the electrical device 270 includes a line sensing circuit 224 connected to the input terminals 211a, 211b. The line sensing circuit 224 includes a circuit arrangement that generates one or more control signals 225 to switch the switch 223 on or off in dependency of the input voltage applied to the input terminals 211a, 211b.

In the following drawings, the same and the similar elements of different embodiments are denoted by similar reference numerals differing by the hundreds digit if they are depicted in different drawings.

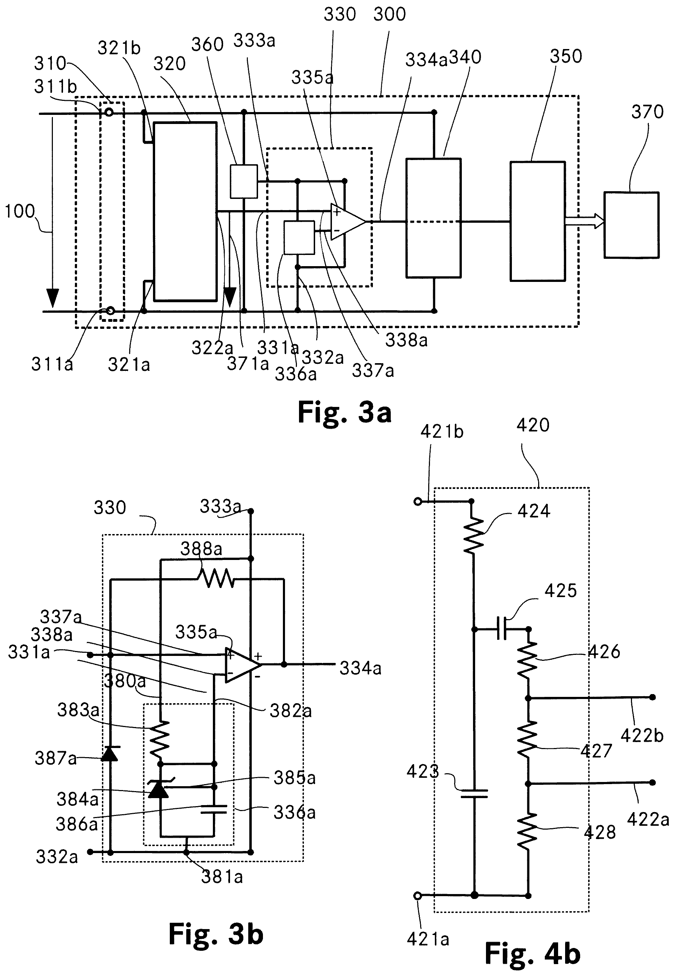

The block diagram in Fig. 3a shows a first embodiment of a circuit arrangement 300 according to the invention, including an AC-input port 310 for connecting an AC voltage 100 such as a domestic AC-input line to the circuit arrangement 300. It further comprises a band-pass filter 320, a threshold detection circuit 330, a transfer circuit 340, a threshold detection logic 350 and a DC supplying circuit 360. The circuit arrangement allows the unipolar detection of threshold crossings of positive or negative half waves of the AC voltage for one single threshold level.

The AC-input port 310 for connecting an AC voltage comprises a first input terminal 311a and a second input terminal 311b. When sensing a main voltage, the first input terminal 311a may be connected to the Neutral (N) while the second input terminal 311b may be connected to the Line (L), but it is also possible to connect the first input terminal 311a to the Line (L) and the second input terminal 311b to the Neutral (N), or to connect the first input terminal 311a to a first Line (L1) and the second input terminal 311b to a second Line (L2).

The band pass filter 320 comprises a first filter input terminal 321a, a second filter input terminal 321b and a first filter output 322a.

The threshold detection circuit 330 comprises a first voltage input 331a, a first reference terminal 332a, a first DC-power supply input 333a and a first detection output 334a. It further comprises a first comparator element 335a, the comparator element preferably comprising an operational amplifier, and a first reference voltage circuit 336a.

The first filter input terminal 321a of the band-pass filter 320 is connected to the first input terminal 311a, the second filter input terminal 321b of the band-pass filter 320 to the second input terminal 311b and the first filter output 322a to the first voltage input 331a of the threshold detection circuit 330 for providing a first output signal 371a to the threshold detection circuit 330. The first output signal 371a is referenced to the first input terminal 311a respectively to the first reference terminal 332a of the threshold detection circuit 330, which is connected to the first input terminal 311a. The band-pass filter 320 has a substantially non-unity-gain in the pass-band, the gain of the band-pass filter 320 respectively the first scaling factor being defined by the quotient between the first output signal (371a) and the voltage between the first and the second filter input terminal (321a, 321b) respectively the voltage applied at the AC input port (310). Thus the filter output signal 371a is scaled by the first scaling factor in reference to the AC voltage. Usually the bass-band-gain of the pass-band filter 320 is chosen to be much smaller than the unity gain, such that low-voltage semiconductor components can be used in the threshold detection circuit 330.

The first comparator element 335a comprises a positive comparator input 337a and a negative comparator input 338a. The positive comparator input 337a is connected to the first voltage input 331a of the threshold detection circuit 330, the negative comparator input 338a to an output of the first reference voltage circuit 336a. The first reference voltage circuit 336a supplies at its output a stable und constant reference voltage to the first comparator element 335a, which is referenced to the first reference terminal 332a. An output of the first comparator element 335a is connected to the first threshold detection output 334a of the threshold detection circuit 330. A signal is generated at the first threshold detection output 334a if a threshold has been passed, respectively if the AC voltage 100 has exceeded a defined threshold or if it has fallen below a defined threshold.

The first threshold detection output 334a is connected to a transfer circuit 340, which comprises a signal transfer circuit. The signal transfer circuit detects logical signal changes at the threshold detection output and transmits a signal, preferably a digital impulse via the transfer circuit 340 which is connected to a first input of the threshold detection logic 350. The transfer circuit galvanically decouples the threshold detection circuit 330 from the threshold detection logic 350.

The threshold detection logic 350 handles the signals received from the transfer circuit and generates an output signal depending on the threshold levels detected. The output signal may switch on or off an electrical device 370.

The DC supplying circuit 360 supplies the DC-power to active elements of the threshold detection circuit 330. An output of the DC supplying circuit 360 is connected to the first DC power supply input 333a of the threshold detection circuit 330. The DC supplying circuit supplies a DC supply voltage in respect to the first input terminal 311a. This DC supply voltage is needed to feed the comparator element 335a and the first reference voltage circuit 336a. The DC supplying circuit is directly powered by the AC voltage being connected to the first and second input terminal 311a, 311b.

Fig. 3b shows the threshold detection circuit 330 of the second embodiment of the circuit arrangement according to Fig. 3a in more detail. It shows the detailed interconnection of the comparator element 335a, here an operational amplifier, and the first voltage reference circuit 336a. The threshold detection circuit 330 comprises also a first diode 387a which is connected with its anode to the first reference terminal 332a of the threshold detection circuit 330 and with its cathode to the first voltage input 331a of threshold detection circuit and to the positive comparator input 337a. The purpose of the diode is to protect the comparator element 335a against high negative voltages. The comparator element is powered by a DC supply voltage which is provided by a first DC power supply input 333a. A first feedback resistor 388a is connected between the output of the first comparator element 335a respectively the first threshold detection output 334a and the positive comparator input 337a, providing positive feedback. By providing positive feedback hysteresis is added to the comparator.

Fig. 3b shows in detail the first voltage reference circuit 336a. The first voltage reference circuit 336a comprises a positive supply input 380a for connecting a DC supply voltage, a negative supply input 381a for connecting the reference of the DC supply input and a voltage reference output 382a. The voltage reference circuit generates a precise reference voltage at the voltage reference output 382a which is referenced to the negative supply input 381a. A resistor 383a is connected with its first terminal to the positive supply input 380a and with its second terminal to a cathode of a shunt regulator element 384a. Said shunt regulator element 384a is connected with its anode to the negative supply input 381a. Preferably an adjustable precision Zener shunt regulator is chosen, as for instance a ZR 431, because of its low power consumption. It further has the advantage that the reference voltage at the first voltage reference output 382a can be adjusted wherein the first voltage reference output depends on the wiring of a voltage reference setting input 385a. In this embodiment it is connected to the voltage reference output 382a, such that the reference voltage at the output is 2.5V. The first voltage reference circuit 336a further comprises a smoothing capacitor 386a which is connected in parallel to the shunt regulator element 384a with one terminal to the negative comparator input 338a and with the other terminal to the negative supply input 381a.

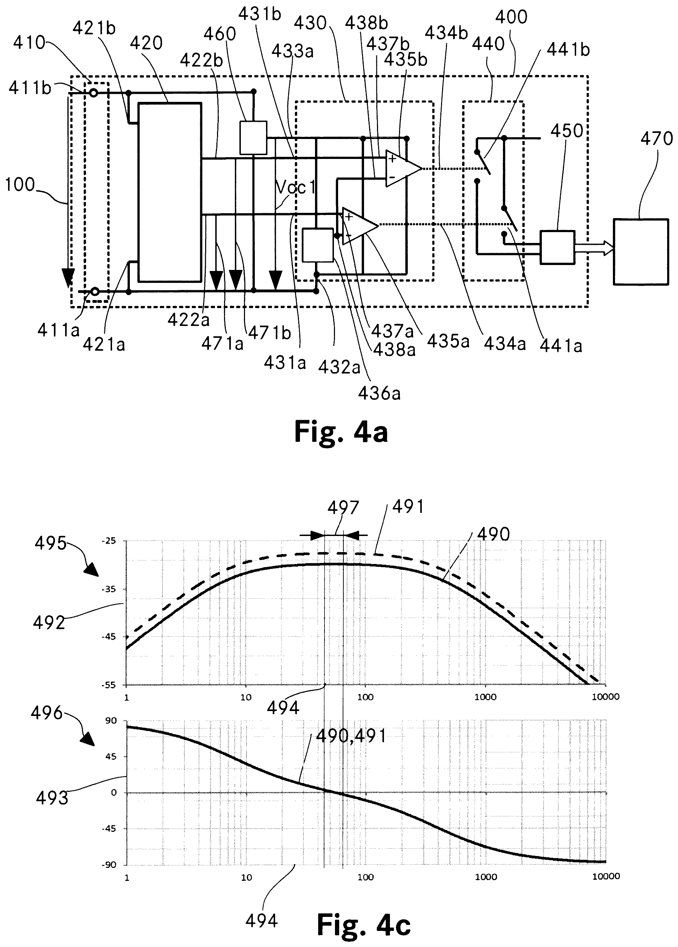

Fig. 4a shows a block diagram of a second embodiment of a circuit arrangement according to the invention. This embodiment of the circuit arrangement 400 is similar to the embodiment shown in Fig. 3a, but it allows the unipolar detection of threshold crossings of positive or negative AC voltage half waves of two different voltage thresholds levels. It includes an AC-input port 410 for connecting an AC voltage to the circuit arrangement 400. It further comprises a band-pass filter 420, a threshold detection circuit 430, a transfer circuit 440, a threshold detection logic 450 and a DC supplying circuit 460.

The band-pass filter 420 comprises a first filter input terminal 421a, a second filter input terminal 421b, a first filter output 422a and, in addition to the first embodiment of the invention, a second filter output 422b. The first filter input terminal 421a of the band-pass filter 420 is connected to the first input terminal 411a, the second filter input terminal 421b of the band-pass filter 420 to the second input terminal 411b.

The threshold detection circuit 430 comprises a first voltage input 431a, a second voltage input 431b, a first reference terminal 432a, a first DC-power supply input 433a, a first detection output 434a and a second detection output 434b.

The band pass filter 420 provides a first output signal 471a on the first filter output 422a and a second output signal 471b on the second filter output 422b. Both signals are referenced to the first input terminal 411a respectively to the first reference terminal 432a of the threshold detection circuit 430, the first reference terminal 432a being connected to the first input terminal 411a. The first filter output 422a is connected to the first signal input 431a of the threshold detection circuit 430 and the second filter output 422b is connected to the second signal input 431b of the threshold detection circuit 430.

Similar to the embodiment shown in Fig. 3a this embodiment includes only one voltage reference circuit 436a and only one DC supplying circuit 460.

The threshold detection circuit 430 further comprises two comparator elements, a first comparator element 435a and a second comparator element 435b, both preferably comprising an operational amplifier and both comprising a positive comparator input 437a, 437b and a negative comparator input 438a, 438b. The positive comparator input 437a, 437b of the first comparator element 435a is connected to the first filter output 422a respectively the first signal input 431a, the positive comparator input 437b of the second comparator 435b is connected to the second filter output 422b respectively to the second signal input 431b. The negative comparator inputs 438a and 438b are both connected to an output of a first voltage reference circuit 436a. The different threshold levels are achieved by using different scaling factors at the outputs 422a, 422b of the band pass filter 420. The threshold detection circuit 430 comprises two threshold detection outputs. A first threshold detection output 434a which is connected to the output of the first comparator element 435a and a second threshold detection output 434b which is connected to the output of the second comparator element 435b. The first threshold detection output 434a is also connected to a first controllable switch 441a of the transfer circuit 440, the second threshold detection output 434b to a second controllable switch 441b of the transfer circuit 440. The controllable switches 441a, 441b generate two galvanically decoupled signals which are transmitted to the threshold detection logic 450. The threshold detection logic 450 generates control signals for a connected electrical device 470.

The DC supplying circuit 460 supplies a first DC supply voltage Vcc1 to the active elements of the threshold detection circuit 430. Therefore an output of the DC supplying circuit 460 is connected to the first DC power supply input 433a of the threshold detection circuit 430. The DC supplying circuit 460 supplies the DC supply voltage Vcc1 in respect to the first input terminal 411a. The DC supply voltage Vcc1 is needed to feed the first and the second comparator element 435a; 435b and the first reference voltage circuit 436a. The DC supplying circuit 460 is directly powered by the AC voltage 100 being connected to the first and second input terminal 411a, 411b.

Fig. 4b shows a detailed schematic diagram of a band-pass filter 420 according to the second embodiment of the circuit arrangement, as shown in Fig. 4a. The band-pass filter comprises a first filter input terminal 421a and a second filter input terminal 421b, a first filter output 422a and a second filter output 422b. It further comprises a first RC circuit, including a first capacitor 423 and a first resistor 424, and a second RC circuit, including a second capacitor 425 and a resistive voltage divider which is formed by a series connection of second resistor 426, a third resistor 427 and a forth resistor 428. Said first capacitor 423 of said first RC circuit is connected with a first terminal to the first filter input terminal 421a. With its second terminal said first capacitor 423 is connected to a first terminal of the first resistor 424. Said first resistor 424 is connected with its second terminal to the second filter input terminal 421b. Said second RC circuit is connected with a first terminal of the second capacitor 425 to a tap between said first capacitor 423 and said first resistor 424. A second terminal of the second capacitor 425 is connected to a first terminal of the second resistor 426. Said second resistor 426 is connected with a second terminal to a first terminal of the third resistor 427. A second terminal of said third resistor 427 is connected to a first terminal of a forth resistor 428. A second terminal of said forth resistor 428 is connected to the first input terminal 421a. The first filter output 422a is connected to tap between the third resistor 427 and the forth resistor 428. The second filter output 422b is connected a tap between the second resistor 426 and the third resistor 427.

The filter shown in Fig. 4b represents a second order band-pass
This second order band-pass filter is designed to have a flat behaviour in the region of the of the supported fundamental frequency range 497 (Fig. 4c), namely 45 to 65 Hz, cutting out the relevant frequency range. This allows covering fundamental frequencies of almost all common international domestic power supplies. The band-pass filter 420 has a lower - 3dB cut-off frequency of approximately 5 Hz and a higher -3dB cut-off frequency of approximately 600 Hz. The centre frequency of the band-pass filter is therefore chosen in the middle of the fundamental frequency range 497 at 55 Hz. The phase shift in the fundamental frequency range 497 between 45 Hz and 65 Hz should is with +/-3 degrees very small, also the gain difference of 0.01 dB. These characteristics are achieved with the following components:

| First Capacitor | 423: | 1 | nF |
|---|---|---|---|
| Second Capacitor | 425: | 10 | nF |
| First Resistor | 424: | 409 | kOhm |
| Second Resistor | 426: | 68.1 | kOhm |
| Third Resistor | 427: | 20 | kOhm |
| Forth Resistor | 428: | 2 | MOhm |

The filter having one input signal and two output signals is described by two transfer functions.

Fig. 4c shows the bode plots of a first transfer function 490 between the AC voltage 100 and the first output signal 471a and the bode plot of a second transfer function 491 between the AC input voltage 100 and the second output signal 471b (Fig. 4a). The bode plot displays the magnitude 492 (in dB) and the phase 493 (in degrees) of the system response as a function of frequency 494. A magnitude plot 495 and a phase plot 496 of the system response of the first transfer function 490 are displayed in full lines, while the magnitude plot and the phase plot of the system response of the second transfer function 491 are displayed in dashed lines. As both transfer function only differ in the scaling factor the magnitude plots of both transfer functions are simply shifted in the direction of the y-axis respective the gain axis 492. In the fundamental frequency range 497 between 45 and 65 Hz, the magnitude gain plot is almost flat, only dropping by 0.01 dB inside this frequency range. Such the sensed thresholds are independent from the line voltage frequency as fundamental frequencies of domestic power systems do not exceed this frequency range. The first filter output signal is attenuated at the centre frequency of 55 Hz by -29.9 dB respectively to approximately 3% of the input voltage, which corresponds to the first scaling factor, the second filter output signal by -27.7dB respectively to approximately to 4 % of the input voltage, which corresponds to the second scaling factor.

The phase plots of both transfer functions 490 and 491 are identical. The phase shift of the transfer varies almost linearly between + 3 degrees and -3 degrees in the fundamental frequency range.

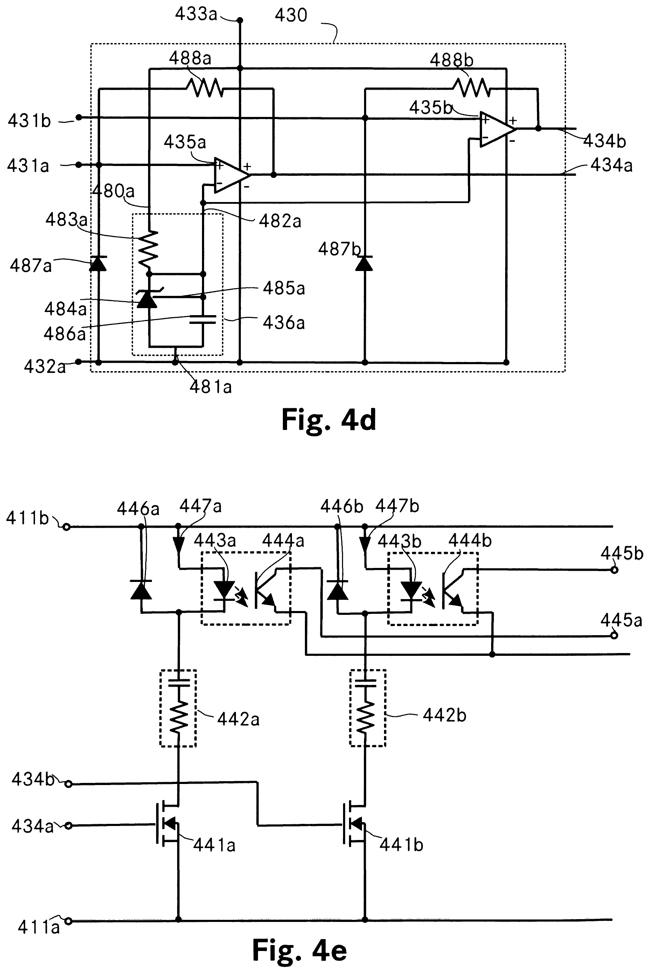

Fig. 4d shows the threshold detection circuit 430 of the second embodiment of the circuit arrangement according to Fig. 4a in more detail. It shows the detailed interconnection of the two comparator elements 435a, 435b, here realised by two operational amplifiers, and the first voltage reference circuit 436a. The threshold detection circuit 430 comprises also a first diode 487a which is connected with its anode to the first reference terminal 432a of the threshold detection circuit 430 and with its cathode to the first voltage input 431a of threshold detection circuit. It may also comprise a second diode 487b being connected with its anode to the first reference terminal 432a of the threshold detection circuit and with its cathode to the second voltage input 431b of the threshold detection logic 430. The purpose of the diodes is to protect the comparator elements 435a and 435b against high negative voltages. Depending on the realisation of the filter, one of both diodes 487a and 487b may be avoided. For a realisation of the filter according to Fig. 4c the second diode 487b is redundant. The comparator elements 435a; 435b are powered by the first DC supply voltage Vcc1 voltage which is provided by a DC power supply input 433a. A first feedback resistor 488a is connected between the output of the first comparator element 435a respectively the first threshold detection output 434a and the first signal input 431a, providing positive feedback, a second feedback resistor 488b is connected between the output of the second comparator element 435b respectively the second threshold detection output 434b and the second signal input 431b. By providing positive feedback hysteresis is added to the comparators elements 435a, 435b.

Fig. 4d shows in detail the first voltage reference circuit 436a. The first voltage reference circuit 436a comprises a positive supply input 480a for connecting a first DC supply voltage Vcc1, a negative supply input 481a for connecting the reference of the DC supply voltage Vcc1 and a voltage reference output 482a. The first voltage reference circuit 436a generates a precise reference voltage at the voltage reference output which 482a is referenced to the negative supply input 481a. A resistor 483a is connected with its first terminal to the positive supply input 480a and with its second terminal to a cathode of a shunt regulator element 484a. Said shunt regulator element 484a is connected with its anode to the negative supply input 481a. Preferably an adjustable precision Zener shunt regulator is chosen, as for instance a ZR 431, because of its low power consumption. It further has the advantage that the reference voltage at the voltage reference output 482a can be adjusted wherein the reference voltage at reference output 482a depends on the wiring of a voltage reference setting input 485a. In this embodiment it is directly connected to the voltage reference output 482a, such that the reference voltage at the output is set 2.5V. The first voltage reference circuit 436a further comprises a smoothing capacitor 486a which is connected in parallel to the shunt regulator element 484.

Fig. 4e shows the transfer circuit 440 according to the second embodiment in further detail. The transfer circuit 440 comprises a first controllable switch 441a and a second controllable switch 441b. In this embodiment the first and the second controllable switch 441a, 441b are realized by means of a first n-MOSFET transistor 441a and a second n-MOSFET transistor 441b. A gate of the first n-MOSFET transistor 441a is connected to the first detection output 434a of the threshold detection circuit 430 (Fig. 4a), and a gate of the second n-MOSFET transistor 441b to the second output 434b of the threshold detection circuit 430 (Fig. 4a). The sources of said n-MOSFET transistors 441a and 441b are both connected to the first input terminal 411a. The drain of the first n-MOSFET 441a is connected to a first terminal of a first RC circuit 442a and the drain of the second n-MOSFET 441b is connected to a first terminal of a second RC circuit 442b. A second terminal of the first RC circuit 442a is connected to a cathode of a first light emitting photo diode (LED) 443a, said LED 443a being connected with its anode to the second input terminal 411b. A second terminal of the second RC circuit 442b is connected to a cathode of a second LED 443b, said LED 443b being connected with its anode to the second input terminal 411b. A first free-wheeling diode 446a is connected anti-parallel to the first LED 443a, and a second free-wheeling diode 446b is connected anti-parallel to the second LED 443b. Both free-wheeling diodes are necessary for discharging the loaded capacitors of both RC circuits 442a and 442b during negative half-waves of the AC Input voltage 100.

The RC-circuit 442a/442b differentiates the applied AC line voltage when a positive voltage is applied at the first/second voltage detection output 434a/434b respectively to the gate of the first/the second n-MOSFET 441a /441b and a current spike is created. Due to the phase shift of the band-pass filter of around zero degrees, the voltage during the turn-on of the n-MOSFET 441a/441b is high enough to create a current spike being high enough to be transferred by the optocoupler. The elements of the RC circuit can for example be chosen as follows:

Resistors: 1 kOhm

Capacitor: 1nF

Those values yield a short switching time of approximately 10us, yielding a moderate power dissipation of around 10mW.

In response to the passing of the first/second threshold, the second/first n-MOSFET 441b, 441a switches. Therefore, the complete voltage across the second/first n-MOSFET 441b/441a will instantaneously drop, thus the whole AC voltage 100 will shift to the resistors of the RC circuit 442b/442a and a virtually pulse-shaped current flow with an e-function gradient will result. The current has to be sufficient to activate the LEDs. With the components indicated below a maximum current of more than 80 mA is generated, which is sufficient to activate the LEDs. A resulting current flow 447b/447a through the second/first LED 443a, 443b will activate a first/second photo transistor 444a, 444b and generate a signal on the first/second output terminal 445b, 445b of the transfer circuit 450. The switching time can be optimized by adequately selecting the components of the RC circuit.

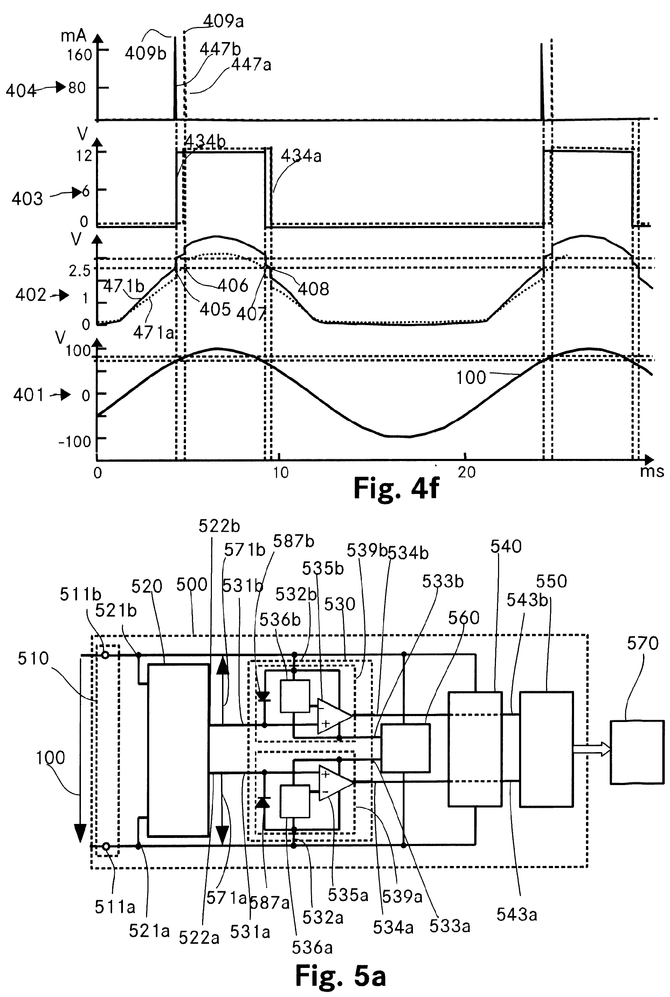

Fig. 4f shows a typical signal sequence for an AC voltage 100 applied at the input port 410 between the first input terminal 411a and the second input terminal 411b of the circuit arrangement according to the second embodiment of the invention (Fig. 4a). AC Input voltage plot 401 shows the graph of the AC voltage 100 with an amplitude of 100V (71 Vrms) applied between the first input terminal 411a and the second input terminal 411b. Filter output plot 402 shows a corresponding first graph of the first output signal 471a (at the first filter output 422a, displayed in a dotted line) and a second graph of a second output signal 471b (at the second filter output 422b, displayed in a full line). An output signal plot 403 shows the output signal at the first threshold detection output 434a and the second threshold detection output 434b. An impulse current plot 404 shows the corresponding currents through the LEDs 443a and 443b, of the transfer circuit (Fig. 4e).

Because of the blocking diodes 487a and 487b the filter output signals 471a and 471b are almost unipolar. The resistive divider of the band-pass filter (Fig. 4b) (second, third and fourth resistor 426,427,428) attenuates the first filter output signal 471a in respect to the AC voltage 100 by -29.9dB (or by 1/31.3) respectively the second filter output signal 471b in respect to the AC voltage 100 by -27.7dB (or by 1/24.3), such that both comparator elements 435a and 435b sense a different voltage resulting in time shifted signals at the output of the threshold detection circuit. The blocking diodes 487a and 487b are limiting the amplitudes of the negative half waves to -0.7V which protects the comparator elements 435a and 435b. Due to the hysteresis of the comparator elements 435a and 435b with the positive feedback paths, also the shape of the positive half-waves of the curves is non-sinusoidal. Every time when a comparator switches its output from low to high respectively from 0 to Vcc1 (0V to 12V), the voltage at its input increases and if a comparator switches its output from high to low (12V to 0V), the voltage at its input decreases. This ensures a hysteresis and a fast switching of the comparator output. Furthermore any present noise can be suppressed. In this example the hysteresis is around 0.5 V. At 0 ms the AC-input signal 100 is increasing. As the second output signal 471b is with -27.7 dB or (1/24.3) less attenuated than the first output signal 471a with - 29.9dB or (1/31.3), the second output signal 471b reaches the reference voltage level of 2.5 V first and therefore defines the first respectively the lower threshold. This first threshold is reached in a first switching point 405 at an AC voltage 100 of approximately 73V. This value can be calculated by multiplying the inverse of the second scaling factor with the sum of the reference voltage and the hysteresis value (24.3*(2.5V +0.5V)). In the first switching point 405 the second comparator element 435b switches then from FALSE to TRUE respectively the voltage at the threshold detection output 434b from 0 to 12V. This activated the n-MOSFET transistor 441b yielding a peak like current flow 447b through the LED 443b, the current having a current peak 409b with an amplitude of more than 100mA and an impulse width of about 35 us and wherein the current flow 447b decays exponentially. Because of the positive feedback, also the voltage of both filter outputs 422a and 422b is increased. With a further increasing AC input voltage, the second threshold of approximately 82V is reached, when the first output signal 471a reaches the reference voltage of 2.5 V in a second switching point 406. The first comparator element 435a switches then from FALSE to TRUE respectively the voltage at the threshold detection output 434a from 0 to 12V. This activates the n-MOSFET transistor 441a yielding another peak like current flow 447a through the LED 443a, the current having a current peak 409a with an amplitude of more than 100mA and an impulse width of about 35 us and wherein the current flow 447a decays exponentially. In this moment the voltage of both output signals is further increased by the hysteresis (approximately 0.4 V) which corresponds to the hysteresis of the first comparator stage. After the AC voltage 100 having reached the peak value at 7ms, the first output signal 471a drops in a third switching point 407 below the reference voltage of 2.5 V which corresponds to an AC input voltage 100 of approximately. 68V, which causes the first comparator to switch from TRUE to FALSE, such that also the scaled voltage signals 471a and 471b will be decreased by the hysteresis due to the positive feedback. Finally also the first voltage level will be reached in a forth switching point 408 at an AC input voltage of around 61 V, when the second output signal 471b crosses again the 2.5V reference line. The sequence will be periodically repeated with the next positive half wave of the AC voltage 100.

Fig. 5a shows a third embodiment of a circuit arrangement 500 according to the invention which allows the bipolar detection of threshold passings of the AC voltage 100 for two different thresholds, a first threshold for positive AC voltage half-waves and a second threshold for negative AC voltage half-waves. The circuit arrangement 500 is symmetrical in respect of the AC voltage 100.

This embodiment is similar to the embodiment shown in Fig. 3a or Fig. 4a. It also includes an AC-input port 510 for connecting an AC voltage 100, a band-pass filter 520, a voltage detection circuit 530, a transfer circuit 540, a threshold detection logic 550 and a DC supplying circuit 560.

The band-pass filter 520 has a first filter input terminal 521a which is connected to a first input terminal 511a of the AC-Input port 510 and a second filter input terminal 521b which is connected to a second input terminal 511b of the AC input port 510. The band-pass filter further comprises a first filter output 522a and second filter output 522b. The first filter output 522a provides a first output signal 571a which is referenced to the first input terminal 511a of the AC-input port. The second filter output 522b provides a second output signal 571b which is in contrast to the embodiments of Fig. 3a and Fig. 4a referenced to the second input terminal 511b.

The threshold detection circuit 530 is symmetrical in respect to the AC input voltage. It comprises a first voltage input 531a and a second voltage input 531b, a first reference terminal 532a, a second reference terminal 532b, a first DC power supply input 533a, a second DC power supply input 533b, a first threshold detection output 534a and a second threshold detection output 534b. The first voltage input 531a is connected to the first filter output 522a and the second voltage input 531b to the second filter output 522b. The first reference terminal 532a is connected to the first input terminal 511a of the AC-input port 510 and the second reference terminal 532b to the second input terminal 511b of the AC-input port 510.

The active elements of the threshold detection circuit 530 are provided with a first DC supply voltage Vcc1 and a second DC supply voltage Vcc2 which are generated by the DC supplying circuit 560.

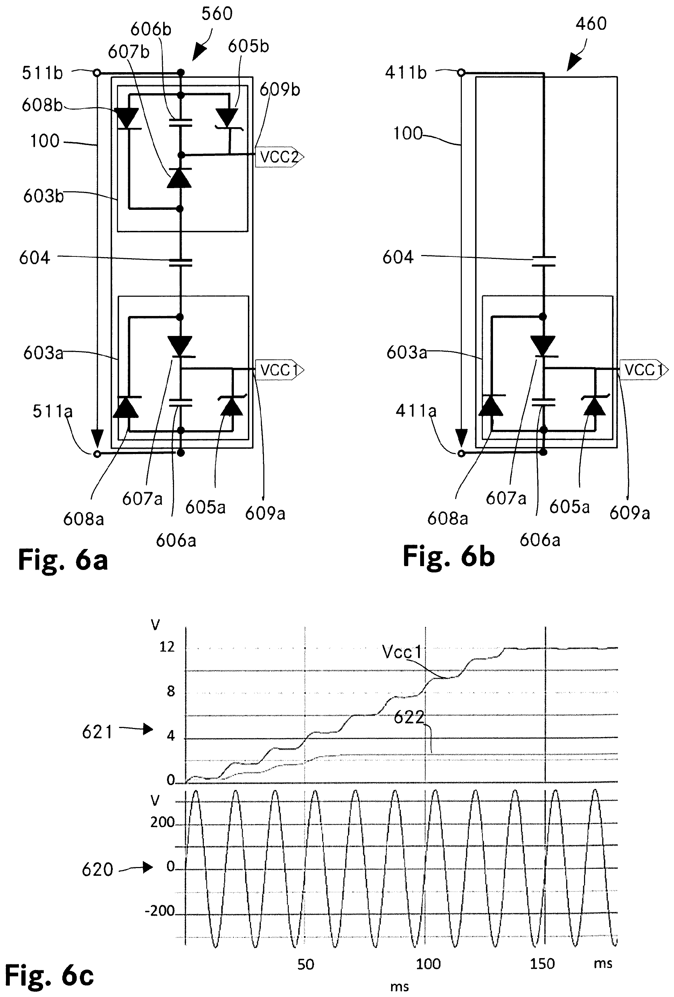

For this purpose the first DC power supply input 533a of the threshold detection circuit 530 is connected to a first DC supply output 609a (Fig. 6a) of the DC supplying circuit 560 which supplies a first DC supply voltage Vcc1, whereas the second DC power supply input 533b of the threshold detection circuit 560 is connected to a second DC supply output 609b (Fig. 6a) of the DC supplying circuit 560 which supplies a second DC supply voltage Vcc2. The DC supplying circuit 560 is connected between the first and the second input terminal 511a, 511b of the AC input port 560, generating the first DC supply voltage Vcc1 and the second DC supply voltage Vcc2 from the AC voltage 100.

The threshold detection circuit further comprises a first comparator circuit 539a which allows detecting threshold passings of positive AC voltage half waves and a second comparator circuit 539b, which is similar to the first comparator circuit 539a, and allows detecting threshold passings of negative AC voltage half waves.

As both comparator circuits are similar, they will be described together while both corresponding identification references will be given.

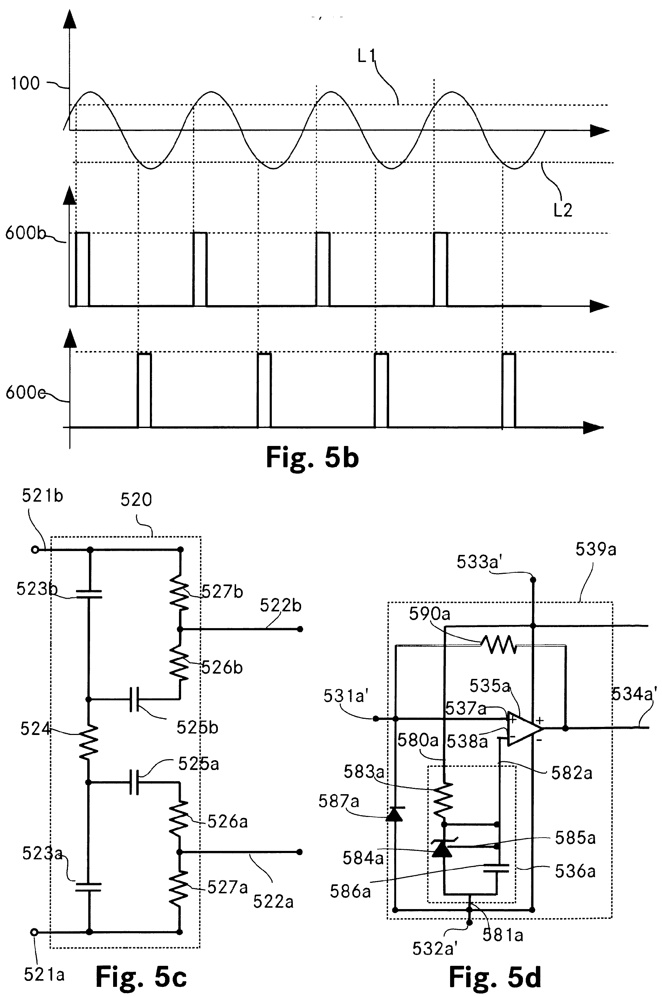

The first/second comparator circuit comprises a first/second voltage reference circuit 536a, 536b, a first/second comparator element 535a, 535b and a first/second diode 587a, 587b. The first/second comparator circuit 539a, 539b comprises an input 531a'; 531b', an output 534a'; 534b'and a reference terminal 531a'; 531b' (Fig. 5d). The signal input 531a'; 531b' of the first/second comparator circuit 539a, 539b is connected to the first/second voltage input 531a; 531b of the threshold detection circuit 530, the output 531a'; 531b' of the first/second comparator circuit 539a, 539b to the first/second threshold detection output 534a, 534b and the reference terminal 531a'; 531b' of the first/second comparator circuit 539a; 539b to the first/second reference terminal 532a, 532b of the threshold detection circuit 530.

The first/second comparator circuit 539a; 539b comprises a comparator element 535a; 535b for comparing a voltage at the input of the comparator circuit to a reference voltage. The first/second comparator circuit also includes a first/second voltage reference circuit 536a; 536b which generates said reference voltage.

A detailed circuit diagram of the first and the second comparator circuit is depicted in Fig. 5d and described further down.

The threshold detection outputs are connected via the transfer circuit 540 to the threshold detection logic 550. The first threshold detection output 534a is connected via the transfer circuit to a first input 543a of the threshold detection logic 550, the second threshold detection output 534b is connected via the transfer circuit 540 to a second input 543b of the threshold detection logic 550. The transfer is galvanically decoupling the threshold detection logic 550 from the threshold detection circuit 530. The threshold detection logic 550 generates control signals for a connected electrical device 570.

Fig. 5b depicts possible sequences at the inputs of the threshold detection logic for a circuit arrangement according to Fig. 5a which allows the bipolar detection of threshold passings for positive and negative half waves of the AC voltage 100. The AC voltage 100 plot 600a shows the AC voltage 100 in function of the time, a first threshold level L1 for the positive half wave and a second threshold level L2 for a negative half wave of the AC voltage 100.

Each time when the AC voltage 100 passes the first threshold level L1 in positive direction a logic impulse is generated at the first input of the threshold detection logic 543a (Fig. 5a). The corresponding signal sequence is shown in a positive threshold detection plot 600b.

Each of them when the AC voltage 100 passes the second threshold level L2 in negative direction a logic impulse is generated at the second input of the threshold detection logic 543b (Fig. 5a). The corresponding signal sequence is shown in a negative threshold detection plot 600c.

The levels of the thresholds can be selected independently.

Fig. 5c shows a detailed schematic diagram of a band-pass filter 520 according to the third embodiment of the circuit arrangement, as shown in Fig. 5a.

The band-pass filter 520 comprises a first filter input terminal 521a and a second filter input terminal 521b, a first filter output 522a and a second filter output 522b. The design of the filter is symmetrical in respect of its input and output terminals. This includes its topology as well as its components. The band-pass filter 520 further comprises a longitudinal RC circuit, including a first capacitor 523a, a first resistor 524, a second capacitor 523b and a first transverse RC circuit, including a third capacitor 525a and a first resistive voltage divider which is formed by a series connection of second resistor 526a and a third resistor 527a. It also comprises a second transverse RC circuit including a forth capacitor 525b and a second resistive voltage divider which is formed by a forth resistor 526b and a fifth resistor 527b.

Said first capacitor 523a of said longitudinal RC circuit is connected with a first terminal to the first filter input terminal 521a and with its second terminal to a first terminal of the first resistor 524. Said second capacitor 523b of said longitudinal RC circuit is connected with a first terminal to the second filter input terminal 521b and with its second terminal to a second terminal of the first resistor 524.

Said first transverse RC circuit is connected with a first terminal of the third capacitor 525a to a tap between said first capacitor 523a and said first resistor 524. A second terminal of the third capacitor 525a is connected to a first terminal of the second resistor 526a. Said second resistor 526a is connected with a second terminal to a first terminal of the third resistor 527a. A second terminal of said third resistor 527a is connected to the first input terminal 521a.

Said second transverse RC circuit is connected with a first terminal of the forth capacitor 525b to tap between said first resistor 524 and said second capacitor 523b. A second terminal of the forth capacitor 525b is connected to a first terminal of the forth resistor 526b. Said forth resistor 526b is connected with a second terminal to a first terminal of the fifth resistor 527b. A second terminal of said fifth resistor 527b is connected to the second input terminal 521b.

Similarly to the band-pass filter of the second embodiment the band-pass filter 520 is designed to have a flat behaviour in the fundamental frequency range, namely between 45Hz to 65 Hz. The considerations for the filter design are the same as for the filter design of the unipolar versions according to Fig. 4b, the band-pass filter according to Fig. 5c also being a second order filter. The centre frequency of the band-pass is therefore also chosen in the middle of the pass-band at 55 Hz, the phase shift between 45 Hz and 65 Hz in the range of +/- 3 degrees and the gain difference below 0.01 dB.

The filter having one input signal and two output signals is described by two transfer functions.

Fig. 5d shows a detailed diagram of the comparator circuit 539a. This circuit is identical to the comparator circuit 539b and therefore only the comparator circuit 539a is described. It shows the detailed interconnection of the comparator element 535a, here an operational amplifier, and the first voltage reference circuit 536a. A positive input 537a of the comparator element 535a is connected to the signal input 531a' of the first comparator circuit 539a'. A negative input 538a of the comparator element 535a is connected to a voltage reference output 582a of the voltage reference circuit 536a which supplies a reference voltage of 2.5V. An output of the comparator element 535a is connected to the output 534a' of the comparator circuit 539a. A first feedback resistor 590a is connected with one terminal to the output of the comparator element 535a and with the other terminal to the signal input 531a' of the comparator circuit 539a and provides positive feedback and a hysteresis to the comparator element. A first blocking diode 587a is connected with its anode to the reference input 532a' of the comparator circuit 539a and with its cathode to the positive input 537a of the comparator element 535a. The purpose of this diode is to protect the comparator element 535a against high negative voltages.

Fig. 5d shows also a detailed circuit diagram of the first voltage reference circuit 536a. The first voltage reference circuit 536a comprises a positive supply input 580a for connecting a first DC supply voltage Vcc1, a negative supply input 581a for connecting the reference of the DC supply voltage Vcc1 and the voltage reference output 582a. The first voltage reference circuit 536a generates a precise reference voltage at the voltage reference output 582a which is referenced to the negative supply input 581a. A resistor 583a is connected with its first terminal to the positive supply input 580a and with its second terminal to a cathode of a shunt regulator element 584a. Said shunt regulator element 584a is connected with its anode to the negative supply input 581a. Preferably an adjustable precision Zener shunt regulator is chosen, as for instance a ZR 431, because of its low power consumption. It further has the advantage that the reference voltage at the voltage reference output 582a can be adjusted wherein the reference voltage at reference output 582a depends on the wiring of a voltage reference setting input 585a. In this embodiment it is directly connected to the voltage reference output 582a, such that the reference voltage at the output is set 2.5V. The first voltage reference circuit 536a further comprises a smoothing capacitor 586a which is connected in parallel to the shunt regulator element 584.

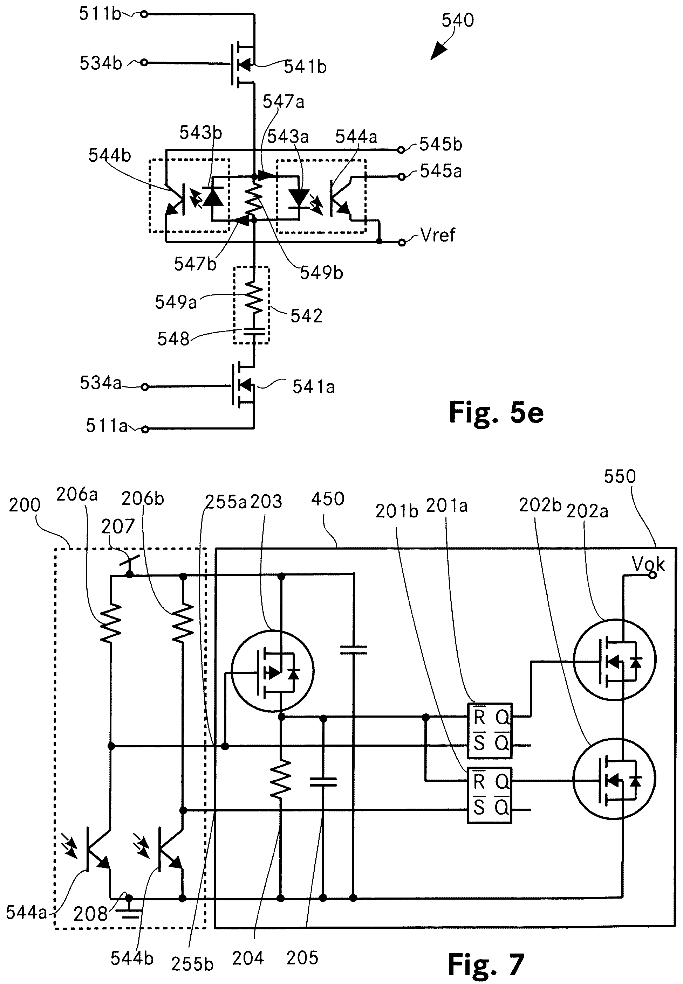

Fig. 5e shows a detailed circuit diagram of the transfer circuit 540 according to the third embodiment of the invention. The transfer circuit comprises a first controllable switch and a second controllable switch. In this embodiment the first and the second controllable switch are realized by means a first n-MOSFET transistor 541a and a second n-MOSFET transistor 541b. A gate of the first n-MOSFET 541a is connected to the first detection output 534a of the threshold detection circuit 530 and a gate of the second n-MOSFET 541b is connected to the second detection output 534b of the threshold detection circuit 530 (Fig 5a, not shown in Fig. 5e). The source of said first n-MOSFET transistor 541a is connected to the first input terminal 511a, the gate of said second n-MOSFET transistor 541b to the second input terminal 511b. A serial RC-circuit 542 and a parallel circuit are connected in series between the drains of the n-MOSFET transistors 541a and 541b. The serial RC-circuit 542 includes a capacitor 548 and a first resistor 549a and is connected with one end to the drain of the first n-MOSFET 541a and with the other end to the parallel circuit, comprising three legs. A first leg includes a second resistor 549b, a second leg a first LED (light-emitting-diode) 543a for transmitting positive threshold signals and a third leg comprises a second anti-parallel LED 543b for transmitting negative threshold signals. The first LED 543a is connected with its cathode to the serial RC circuit and with its anode to the drain of the second n-MOSFET 541b. The second LED 543b is connected with its anode to the serial RC-circuit 542 and with its cathode to the drain of the n-MOSFET.

In response to the passing of positive (negative) threshold, the first/second n-MOSFET 541a, 541b switches. Therefore, the complete voltage across the first/second n-MOSFET 541a, 541b will instantaneously drop, thus the whole voltage 100 will shift to the resistors 549a and 549b and a virtually pulse-shaped current flow with an e-function gradient will result. The current has to be sufficient to activate the respective LED. With the components indicated below a maximum current of about 80 mA is generated, which is sufficient to activate the LEDs. The resulting a current flow 547a, 547b through the first/second photo-diode 543a, 543b will activate a first/second photo transistor 544a, 544b and generate a signal on the first/second output terminal 545a, 545b of the transfer circuit 540. The switching time can be optimized by adequately selecting the components of the RC circuit

The elements of the RC circuit shown in Fig. 5e can for example be chosen as follows:

Capacitor 548: 1nF

Resistor 549a: 10 kOhm

Resistor 549b: 1 kOhm

Those values yield a short switching time of approximately 11us, yielding a moderate power dissipation of around 10mW.

Fig. 6a shows a detailed diagram a bipolar DC supplying circuit 560 according to the third embodiment of the circuit arrangement for supplying a first DC supply voltage Vcc1, which is referenced to the first input terminal 511a and for supplying a second DC supply voltage Vcc2, which is referenced to the second input terminal 511b.

The DC supplying circuit includes a first DC charging circuit 603a, a second DC charging circuit 603b and a capacitor 604.

The AC voltage 100, applied at the input terminals 511a and 511b, is used to charge the capacitor 606a of the first charging circuit 603a and the capacitor 606b of the second charging circuit 603b. The DC supply voltage over the capacitor of the first charging circuit 606a constitutes the first DC supply voltage Vcc1 for powering the first comparator element 535a and the first voltage reference circuit 536a, whereas the DC supply voltage over the capacitor of the second charging circuit 606b constitutes the second DC supply voltage Vcc2 for powering the second comparator element 535b and the second voltage reference circuit 536b (see also Fig. 5a).

The first charging circuit 603a and the second charging circuit 603b are symmetrical in regard to the capacitor 604. The following description therefore applies to the first charging circuit 603a and the second charging circuit 603b.

The first/second DC charging circuit 603a, 603b is connected with a first terminal to the first/second input terminal 511a, 511b, a second terminal is connected to a first/second terminal of the capacitor 604, a third terminal forms the DC supply output 609a, 609b of the first/second charging circuit, supplying the DC supply voltage Vcc1/Vcc2. The first/second charging circuit comprises a Zener diode 605a, 605b, a serial circuit including a capacitor 606a, 606b and an anti-parallel diode 607a, 607b and a parallel diode 608a, 608b connected in parallel to said serial circuit. The parallel diode 608a, 608b is connected with an anode to the input terminal 511a, 511b and with a cathode to the first/second terminal of the capacitor 604. The capacitor 606a, 606b of the first/second charging circuit 603a, 603b is connected with a first terminal to the input terminal 511a, 511b and with a second terminal to the cathode of the anti-parallel diode 607a, 607b of said serial circuit. The anode of the anti-parallel diode, 607a, 607b is connected to the cathode of the parallel diode 608a, 608b and the first/second terminal of the capacitor 604. Therefore, the anti-parallel diode 607a, 607b and the parallel diode 608a, 608b are anti-parallel according to the definition given further above. The Zener diode 605a, 605b is connected in parallel to the capacitor of the first/second charging circuit 606a, 606b. An anode of the Zener diode 605a, 605bis connected to the first terminal of the capacitor 606a, 606b and to the first/second input terminal 511a, 511b and with a cathode to the second terminal of the capacitor 606a, 606b and to the cathode of the anti-parallel diode 607a, 607b.

The circuit works as follows: the capacitor 604 has a small capacity, for instance 10nF, while the capacitor, 606b has a significantly larger capacity, for instance 40 uF respectively 4000 times bigger than the capacity of capacitor 604. When a positive voltage 100 is applied between the input terminals 511a and 511b, the diodes 608b and 607a are conducting. When the voltage rises, the whole input voltage is applied on the capacitors 604 and 606a and the same charge is build up in both capacitors 604 and 606a due to the load displacement principle. The voltage drop across the capacitor 604 is large compared to the voltage drop over the capacitor 606a as the capacity of capacitor 604 is very small compared to the capacity of capacitor 606a.

When the AC input voltage 100 starts to decrease again, the charge will be stored in the capacitor 606a due to the blocking anti-parallel diode 607a while the charge of capacitor 604 will discharge.

If the AC voltage 100 decreases further and becomes negative, the diodes 608a and 607b will become conductive. Then the capacitor 606b will be charged similarly to the capacitor 606a during the positive half wave. When the AC voltage 100 goes up again, the blocking anti-parallel diode 607b turns into blocking state, thus preventing the capacitor 606a from being discharged.

With each complete cycle of the alternating input voltage 100 the charges of two capacitors 606a and 606b increase, until at some point the leakage current due to the input impedance of the connected comparator elements 535a, 535b or the voltage reference circuits 536a, 536b becomes dominant or the voltage rating of the first Zener diode 605a or the second Zener diode 605b will be reached. At this point, the first DC supply voltage Vcc1 and the second DC supply voltage of the second trigger circuit Vcc2 will be reached. The time to build up the DC supply voltage can be optimised by choice of capacitors 604, 606a and 606b.

Fig. 6b shows a detailed diagram of the unipolar version of the DC supplying circuit 460 according to second embodiment of the circuit arrangement according the invention. It is similar to the bipolar version of the DC supplying circuit shown in Fig. 6a, however it does not include a second DC charging circuit 603b. Similar elements in Fig. 6a and 6b are denoted by the same reference numerals. It charges the capacitor of the first charging circuit 606a during the positive half waves of the AC voltage 100 which is applied between the first input terminal 411a and the second input terminal 411b.

Fig. 6c shows a charging cycle of the DC supplying circuit according to Fig. 6b. The lower plot 620 shows the AC voltage 100 as a function of the time. The upper plot 621 shows the corresponding DC supplying Vcc1 and also the outputted reference voltage 622 at the voltage reference output 482a of the first voltage reference circuit 436a (Fig. 4d).

It is seen that a few AC input voltage cycles are needed to charge the capacitor 606a. In this example the DC output voltage Vcc1 of roughly 12 V is reached after approximately 9 cycles, before it is limited by the Zener diode 605a, this corresponds to a charging time of approximately 150ms at a network frequency of 60Hz.

The voltage reference output Vref 1 stabilizes at 2.5 V already after 4 input voltage cycles, when it is stabilized by the shunt regulator 485 after approximately 67 ms.

Fig. 7 shows a schematic diagram of a threshold detection logic 550 according to the invention and a receiving part 200 of a transfer circuit.

This logic detects if the AC voltage 100 has exceeded a minimum starting threshold and if the voltage has not been fallen below a certain voltage threshold by respecting a well-defined hysteresis function.

The threshold detection logic 550 comprises a first signal input 255a and a second signal input 255b which are connected to the receiving part of a transfer circuit 200 which comprises two parallel legs, one including the first npn photo transistor 544a and the other the second npn photo transistor 544b, an emitter being connected to a reference voltage Vref, a collector being connected to a load resistor 206a, 206b, the other end of the load resistors 206a, 206b, being connected to a DC voltage 207. The collector of the first npn-phototransistor 544a is connected to the first signal input 255a of the threshold detection logic 550. This first photo transistor 544a receives a signal from a threshold detection circuit 530 when a positive threshold L1 has been reached. The collector of the second photo-transistor 544b is connected to the second signal input 255b of the threshold detection logic 550. This second photo transistor 544b receives a signal from a threshold detection circuit 530 when a negative threshold L2 has been reached.

The threshold detection logic 550 further comprises a first RS-Flip-Flop 201a and a second RS Flip-Flop 201b, a logical AND-gate including a first n-MOSFET 202a and a second n-MOSFET 202b connected in series and a timer-circuit, realised by a p-MOSFET switch 203 and a parallel RC-circuit comprising a resistor 204 and a capacitor 205. The p-MOSFET switch 203 of the timer circuit is connected with a source to the DC voltage 207 and with a drain to one terminal of the parallel RC circuit. The RC circuit is connected with the other end to the reference voltage Vref. A gate of the p-MOSFET circuit is connected to the first signal input 255a of the threshold detection logic 550.

The first signal input 255a of the threshold detection logic is also connected to the setting input of the first RS flip-flop 201a and to the gate of the p-MOSFET 203. When the positive half wave has reached the threshold, the first signal input 255a will shortly go to low and set the first RS flip-flop 201a. Simultaneously the low-signal at the gate of the p-MOSFET 203 will close the p-MOSFET timer switch 203, short-circuiting the source and the drain of the p-MOSFET. Therefore, the capacitor of the RC-circuit will be loaded by the DC voltage 207.

The second signal input 255b of the threshold detection logic is connected to the setting input of the second RS flip-flop 201b. When the negative half wave of the AC voltage has reached the threshold, the second signal input 255b will shortly go to low and set the second flop 201a.

An output Q of the RS first flip flop 201a is connected to the gate of the first n-MOSFET 202a, an output Q of the second RS flip-flop 201b is connected to the gate of the second n-MOSFET 202b. A source of the first n-MOSFET 202a is connected to a control signal Vok. A drain of the first n-MOSFET 202a is connected to a source of the second n-MOSFET 202b and a drain of the second n-MOSFET 202b to the reference voltage 208.

For this embodiment we have chosen the positive threshold L1 as lower threshold and the negative threshold L2 as upper threshold. That means that the absolute value of the negative threshold L2 is higher in amplitude than of the positive threshold L1.

Assuming a slow-rising sinusoidal input voltage 100, the lower threshold L1 is crossed first. The first RS flip-flop 201a is triggered by the first photo transistor 544a and the output Q is set (output Q=high).

Assuming a further rising AC voltage 100, the upper threshold L2 is finally crossed and the second RS flip-flop 201b is set (output Q=high). Both outputs are linked by the logic AND gate realized by the first n-MOSFET 202a and the second n-MOSFET 202b. If the output of the AND gate is low, then the AC voltage 100 is within the desired range and above the upper (turning-on) threshold.

If the AC voltage falls again below the upper threshold L2 but still stays above the lower threshold L1, then only the first RS flip-flop 201a is permanently triggered with each positive half wave of the AC voltage cycle (lower threshold) and the second RS flip-flop 201b (upper threshold) is not triggered, but stores the result.

In this case, the AC voltage 100 is within the switching thresholds but the output of the AND gate still keeps its value.

Every time the first RS flip-flop 201a is triggered, the p-MOSFET 203 of the timer switch is shortly conducting. This allows recharging the capacitor of the RC timer with each AC-voltage cycle.

If the AC voltage 100 falls further and finally below the lower threshold L1, then the timer circuit is no longer recharged. The voltage of the capacitor 205 which is connected to the reset inputs of both RS flip-flops 201a, 201b, decays with a time constant tau=RC. In the embodiment according to Figure 7 the following components are used:

R204= 68 kOhm

C 205 = 40 uF

Thus, the time constant of the RC timer circuit is approximately 27 ms.

If the voltage of the RC circuit has fallen below a certain threshold, both RS flip-flops 201a, 201b, are finally reset. For the values given above, the RS flop-flops 201a, 201b, are reset if the AC Voltage has been fallen below the lower threshold L1 for more than one AC cycle. The output of the AND gate realized by the n-MOSFETs 202a and 202b will then go to high or tri-state.

This embodiment represent a very cost efficient and simple circuit, while providing a hysteretic function, permitting a fluctuation of the input voltage in a certain range.

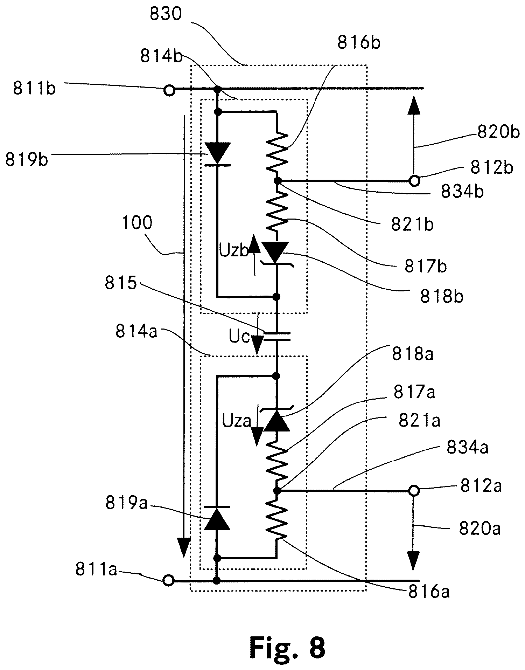

Fig. 8 shows a schematic wiring diagram of a circuit arrangement for detecting a crossing of a threshold by an AC voltage 100 according to the invention. The circuit having a first input terminal 811a and a second input terminal 811b for connecting an AC voltage 100 such as a domestic AC-input line, a threshold detection circuit 830, a first threshold detection output 834a and a second threshold detection output 834b. The threshold detection circuit 830 includes a first threshold setting circuit 814a and a second threshold setting circuit 814b and a capacitor 815.

The first threshold detection output 834a comprises a first output terminal 812a for outputting a signal 820a when the AC voltage 100 between the first input terminal 811a and the second input terminal 811b has passed a positive threshold value L1 in amplitude. The output signal can be sensed as output voltage signal 820a between the first output terminal 812a and the first input terminal 811a.

The second threshold detection output 834b includes a second output terminal 812b for outputting a signal when the AC voltage 100 between the first and the second input terminal has passed a negative threshold value L2 in amplitude. The output signal can be sensed as output voltage 820b between the second output terminal 812a and the second input terminal 81 1b.

The first threshold setting circuit 814a allows detecting threshold passings of the positive half wave of the AC voltage 100. It includes a first voltage divider comprising two resistors 816a and 817a, a Zener diode 818a and a diode 819a. The resistor 817a is connected with one end to the anode of the Zener diode 818a, the resistor 816a with its free end to the input terminal 811a. The cathode of the Zener 818a is connected to the first end of the capacitor 815. The diode 819a is connected with its anode to the input terminal 811a and with its cathode to the capacitor 815, the diode 819a having the same conductive direction as the Zener diode 818a. The first threshold detection output 834a is connected to a first output tap 821a at the connection of the two resistors 816a and 817a of the first voltage divider.

The second threshold setting circuit 814b is mirror symmetrical to the first voltage detection circuit and allows detecting threshold passings of the negative half wave of the AC 100 voltage. It includes a second voltage divider comprising two resistors 816b and 817b, a Zener diode 818b and a diode 819b.

The resistor 817b is connected with one end to the anode of the Zener diode 818b, the resistor 816b with its free end to the input terminal 811b. The cathode of the Zener diode 818b is connected to the second end of the capacitor 815. The diode 819b is connected with its anode to the input terminal 811b and with its cathode to the second end of the capacitor 815 having the same conductive direction as the Zener diode 818b. The second threshold detection output 834b is connected to a second tap 821b at the connection of the two resistors 816b and 817b of the second voltage divider.

The detection threshold of the threshold detection circuit can be set by means of the voltage ratings Uza and Uzb of the Zener diodes 818a and 818b of both threshold setting circuits. By choosing Zener diodes with different voltage ratings different threshold values for the positive and the negative half wave of the AC voltage 100 can be defined.

During the positive half wave of the AC-input signal, when the AC voltage 100 between the input terminals 811a and 811b is positive and building up, the second threshold setting circuit 814b is bypassed by the freewheel-diode 819b. There is only a small forward voltage drop over the diode 819b. Thus almost the whole AC voltage 100 is applied to the first threshold setting circuit 814a which is in blocking state and to the capacitor which has been charged during the precedent negative half wave of the AC voltage 100. When the increasing voltage across the Zener diode 818a exceeds its rated voltage Uza, the Zener diode 818a switches from blocking to breakdown state. The capacitor 815 being precharged from the previous negative AC voltage cycle with the negative voltage Uc,neg, the breakdown voltage of the Zener diode 818a is reached, when the AC voltage (Uin) 100 approximately passes the voltage threshold L1 given by the sum of the voltage of the capacitor 15, Uc,neg, and the breakdown voltage of the Zener diode 818a, Uza:

$$Uin > L1 = Uc,neg + Uza$$

The Zener diode 818a then goes from blocking state to breakdown state, yielding a current flow through the resistors 816a and 817a and to a voltage drop over resistor 816a. The current flow is charging the capacitor 15 as long as the voltage applied to the Zener diode 818a is greater than the Zener breakdown voltage Uza. The resulting impulse like current flow leads to an impulse like voltage 820a between the first output terminal 812a and the first input terminal 811a.

During the negative half wave of the AC-input signal, when the AC voltage 100 between the input terminals 811a and 811b is negative and decreasing, the first threshold setting circuit 814a is bypassed by the freewheel-diode 819a. There is only a small forward voltage drop over the freewheel-diode 819a. Thus almost the whole AC voltage 100 is applied to the second threshold setting circuit 814b which is in blocking state and to the capacitor 815 which has been charged during the precedent positive half wave of the AC voltage 100. When the absolute value of the decreasing voltage across the Zener diode 818b exceeds its rated voltage Uzb the Zener diode 818b switches from blocking to breakdown state. The capacitor 815 being precharged from the previous positive AC voltage cycle with a positive voltage Uc,pos, the breakdown voltage is reached, when the negative input voltage approximately passes the negative voltage threshold L2 given by the sum of the negative voltage threshold value of the Zener 818b, Uzb and the preload voltage of the capacitor 815, Uc,pos. Considering the negative signs, this yields:

$$Uin < L2 = Uc,pos - Uzb$$

The Zener diode 818b then goes from blocking state to breakdown state, yielding a current flow through the resistors 816b and 817b and to a voltage drop over resistor 816b. The current flow is charging the capacitor 15 as long as the voltage applied to the Zener diode 818b is greater in amplitude then the Zener breakdown voltage Uzb.

The resulting impulse like current flow leads to an impulse like voltage 820b between the second output terminal 812b and the second input terminal 811a.

The detection thresholds for the positive half-wave L1 and the negative half wave L2 depend therefore on the breakdown voltage ratings of the Zener diodes Uza and Uzb and the voltages of the capacitor 815 Uc,pos and Uc,neg due to the charging cycle during the previous half wave. Thus the threshold can be adjusted by selecting the voltage ratings of the Zener diodes and by adapting the charging cycle. The charging cycle can be adjusted via the time constant RC of the serial RC circuit which is formed by the capacitor 815 and the resistors 816a and817a, respectively 816b and 817b.

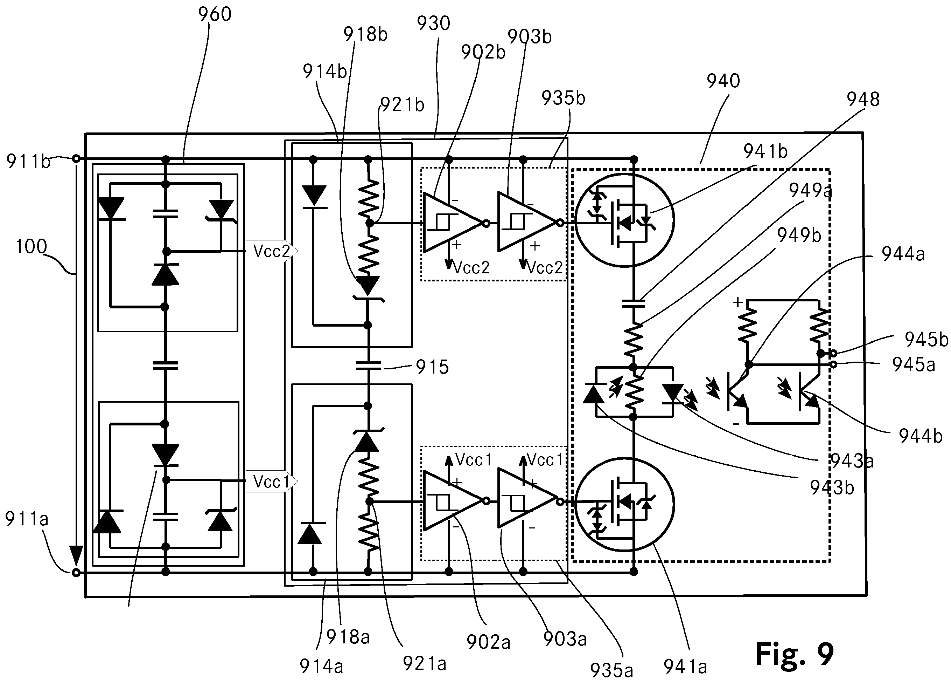

Fig. 9 shows a schematic wiring diagram of another example of a circuit arrangement for detecting a crossing of a threshold by an AC voltage 100 according to the invention. The circuit having two input terminals 911a and 911b for connecting an AC voltage 100 such as a domestic AC-input line and two transfer circuit output terminals 945a and 945b for transmitting a first and a second detection signal to a logical circuit. It comprises a threshold detection circuit 930 which includes a first threshold setting circuit 914a and a second threshold setting circuits 914b, a capacitor 915, a DC supplying circuit 960, a and a transfer circuit 940. The DC supplying circuit 960 is similar to the DC supplying circuit 560 as shown in Fig. 6a. It provides the first DC supply voltage Vcc1 which is referenced the first input terminal 911a and the second DC supply voltage Vcc2 which is referenced to the second input terminal 911b.

The threshold detection circuit 930 includes two similar threshold setting circuits 914a and 914b as described in the embodiment according to Fig. 8. They are connected directly between the input lines 911a and 911b, the cathodes of the Zener diodes 918a and 918b being connected to the capacitor 915. Their function is identical to the function as it has been described for the embodiment according to Fig. 9.

When a positive half wave of the AC-input signal passes a predefined threshold, there will be an impulse like signal on the first output tap 921a, when a negative half wave of the input signal passed a predefined threshold, there will be an impulse like signal on the second output tap 921b.

The threshold detection circuit 930 also includes a first trigger circuit 935a and a second trigger circuit 935b.

The first output tap 921a is connected to an input of the first trigger circuit 935a comprising two similar inverting Schmitt triggers, a first Schmitt trigger 902a and a second Schmitt trigger 903a connected in series. The input of the first trigger circuit 935a is formed by an input of the first inverting Schmitt trigger 902a. An output of the first Schmitt trigger 902a is connected to an input of the second inverting Schmitt trigger 903a. An output of the first trigger circuit 935a is formed by an output of the second inverting Schmitt trigger 903a. The output of the first trigger circuit 935a is connected to the gate of the first n-MOSFET 941a. Both inverted Schmitt triggers 902a and 903a are supplied by a DC supply voltage Vcc1 with reference to the voltage of the first input terminal 911a.

The Schmitt trigger circuit transforms the analogue input signal present at the first output tap 921a into a binary signal which controls the switch 941a. An advantage of the selected Schmitt trigger elements - in addition to their hysteretic function - is that the signal threshold can be easily adapted by changing the supplying voltage Vcc1 of the trigger elements. When the voltage present at the input of the first Schmitt trigger 902a reaches around 2/3 of the supplying voltage Vcc1, the output of the first inverting Schmitt trigger 902a goes from high to low respectively from Vcc1 to 0 V. The low output signal of the first Schmitt trigger 902a will force the output of the second Schmitt trigger 903a to high level respectively to Vcc1. In the present embodiment of the invention the supplying voltage of the trigger is set to 15 V, so that the first trigger circuit 935a switches when the voltage at the output tap of the threshold setting circuit 914a passes 10V which corresponds to 2/3 of the supplying voltage Vcc1, the output voltage of the second trigger element 903a respective of the trigger circuit 935a will then be forced to 15V which corresponds to the supplying voltage of 15V.

In this embodiment two inverting triggers 902a and 903a in series are used instead of one non inverting trigger. The reason is purely commercial, as the selected inverting Schmitt triggers are widely spread standard elements. So they can be provided easier than noninverting trigger circuits. For instance, the MC14102b chip might be used. This chip comprises eight independent inverting Schmitt trigger ports, which can simply be connected in series. It has to be noted that also one non inverting Schmitt trigger or a comparator circuit could be used instead of two inverting Schmitt trigger connected in series.

The second output tap 921b of the second threshold setting circuit 914b is connected to an input of the second trigger circuit 935b comprising two similar inverting Schmitt triggers, a third Schmitt trigger 902b and a fourth Schmitt trigger 903b connected in series. The input of the second trigger circuit 935b is formed by an input of the third inverting Schmitt trigger 902b. An output of the third Schmitt trigger 902b is connected to an input of the fourth inverting Schmitt trigger 903b. An output of the second trigger circuit 935b is formed by an output of the fourth inverting Schmitt trigger 903b. The output of the second trigger circuit 935b is connected to the input of the second controllable switch respectively to the gate of the first n-MOSFET 941b. Both inverted Schmitt triggers 902b and 903b are supplied by a DC supply voltage Vcc2 with reference to the voltage of the second input terminal 911b.

The functionality of the second trigger 935b circuit is similar to the function of the first trigger circuit 935a. It transforms the analogue input signal present at the second output tap 921b into a binary signal which is connected to the gate of the second-MOSFET 941b.

As the first and second n-MOSFET 941a and 941b work fully symmetrical, only the first n-MOSFET 941a will be described below. However, the corresponding identification references of the second n-MOSFET 941b will be indicated too. Both n-MOSFETs 941a and 941b are part of the transfer circuit 940.

The first/second n-MOSFET switch 941a, 941b, is controlled by the output of the first/second trigger circuit 935a, 935b. It is activated to conducting mode, when a threshold of the positive/negative half wave has been detected. A gate of the n-MOSFET 941a, 941b is connected to the output of the first/second trigger circuit 935a, 935b. A source of the n-MOSFET 941a, 941b is connected to the first/second input terminal 911a, 911b, a drain of the first/second n-MOSFET 941a, 941b is connected to a first/second terminal of the transfer circuit.

The n-MOSFETs are always conductive in the direction from source to drain due to their integrated Zener diode. The Zener diode is connected with its anode to the source of the n-MOSFET 941a, 941b and with its cathode to the drain of the n-MOSFET 941a, 941b. When a positive/negative half wave of the AC voltage 100 is present at the input terminals 911a and 911b, the second/first n-MOSFET 941b, 941a is conducting and the first/second n-MOSFET 941a, 941b is blocking as long as the control input has not reached the switching level, respectively as long as the voltage threshold has not been reached. When the threshold value is reached, the output signal of the first/second trigger circuit goes to high, respectively to Vcc1, Vcc2, thus activating the n-MOSFET 941a, 941b via the gate. The n-MOSFET 941a, 941ba will therefore become conducting. As n-MOSFET one can for instance choose a Zener-protected SuperMESH MOSFET of type STD1NK80Z from STM icroelectronics.

The transfer circuit 940 further comprises a serial RC-circuit including a first resistor 949a and a capacitor 948, which is connected with one end to the drain of the second n-MOSFET 941b, with the other end to a parallel circuit, comprising three legs. A first leg includes a resistor 949b, a second leg a parallel LED (light-emitting-diode) 943a for transmitting positive threshold signals and a third leg comprises an anti-parallel LED 943b for transmitting negative threshold signals.

In response to the passing of positive (negative) threshold, the first/second n-MOSFET 941a, 941b switches. Therefore, the complete voltage across the first/second n-MOSFET 941a, 941b will instantaneously drop, thus the whole AC voltage 100 will shift to the resistors 949a and 949b and a virtually pulse-shaped current flow with an e-function gradient will result. The current has to be sufficient to activate the LEDs. With the components indicated below a maximum current of about 80 mA is generated, which is sufficient to activate the LEDs. The resulting current flow through the first/second photodiode 943a, 943b will activate a first/second photo transistor 944a, 944b and generate a signal on the first/second output terminal 945a, 945b of the transfer circuit 940. The switching time can be optimized by adequately selecting the components of the RC circuit The elements of the RC circuit shown in figure 9 can for example be chosen as follows:

Resistor 949a: 10 kOhm

Resistor 949:b 1 kOhm

Capacitor 948: 1nF

Those values yield a short switching time of approximately 11us, yielding a moderate power dissipation of around 10mW.

In summary, it is to be noted that the invention creates a circuit arrangement which protects reliable electrical drives by fast and safe switch off at an AC voltage failure and which is simple and low cost. Furthermore the circuit arrangement minimizes power consumption while being robust against perturbations of the AC input signal. The invention further creates an electrical device including such a circuit arrangement and a corresponding method.

**Claims**

1. A circuit arrangement (300; 400; 500) for an electrical device (570) including components, the circuit arrangement (300; 400; 500) comprising (i) an AC-input port (310; 410; 510) for connecting an AC line voltage (100) of a power network having a fundamental frequency of 45 Hz to 65 Hz and (ii) a threshold detection circuit (330; 430; 530) having a first detection output (334a; 434a; 534a) for outputting a detection signal if a first voltage threshold is crossed by the AC line voltage (100), where the AC-input port (310; 410; 510) includes a first input terminal (211a, 311a, 411a, 511a) and a second input terminal (211b, 311b, 411b, 511b) and the threshold detection circuit (330; 430; 530) includes a first voltage input (331a; 431a; 531a) and a first comparator element (335a; 435a; 535a) for comparing a voltage at the first voltage input (331a; 431a; 531a) to a reference voltage and for outputting the detection signal at the first detection output (334a; 434a; 534a) if said voltage at the first voltage input (331a; 431a; 531a) crosses said reference voltage, said circuit arrangement includes (iii) a band-pass filter (320; 420; 520) connected between the AC-input port (310; 410; 510) and said first voltage input (331a; 431a), **characterized in that** the circuit arrangement (300; 400; 500) comprises (iv) a galvanically decoupling transfer circuit (340; 440; 540), with the first detection output (334a; 434a; 534a) being connected to the galvanically decoupling transfer circuit (340; 440, 540) and with the galvanically decoupling transfer circuit (340; 440; 540) being configured for transmitting the detection signal received from the first detection output (334a; 434a; 534a) to a threshold detection logic (350; 450; 550), and **in that** the circuit arrangement (300; 400; 500) comprises (v) the threshold detection logic (350; 450; 550), with the threshold detection logic (350; 450; 550) comprising a signal input (255a; 255b) being connected to the galvanically decoupling transfer circuit (340; 440; 540), where the threshold detection logic (550) is adapted to generate control signals for enabling or disabling components of the electrical device (570), based on the transmitted detection signal received at the signal input (255a, 255b).

2. A circuit arrangement (300; 400; 500) according to claim 1, the band-pass filter providing a first output signal (371a; 471a; 571a) at a first filter output (322a; 422a; 522a), the first output signal (371a; 471a; 571a) being scaled by a first scaling factor in relation to the AC line voltage (100), where the first voltage input (331a; 431a; 531a) is connected to said first filter output (432a; 422a; 522a).

3. A circuit arrangement (300; 400; 500) according to any of claims 1 to 2, wherein said band-pass filter (420; 520) comprises a second filter output that is scaled by a second scaling factor in relation to the AC line voltage (100), and wherein the threshold detection circuit (430; 530) is adapted to detect a crossing of a second voltage threshold by the AC line voltage (100), where the threshold detection circuit (430; 530) includes a second voltage input (431b; 531b) connected to said second filter output (422b; 522b), a second detection output (434b; 534b) and a second comparator element (435b; 535b) for comparing a voltage at the second voltage input to either said reference voltage or to a second reference voltage and for outputting a detection signal at the second detection output (434b; 534b) if said voltage at the second voltage input crosses said reference voltage or said second reference voltage respectively.

4. A circuit arrangement (300; 400; 500) according to any of the precedent claims, wherein a pass-band (497) of said band-pass filter includes a fundamental frequency range of the AC line voltage (100), and wherein the band-pass filter having a phase shift of the band-pass filter in the fundamental frequency range is below 45° and wherein a gain difference in regard to the respective scaling factors is less than 0.5 dB, said fundamental frequency preferably being between 45Hz and 65Hz, the phase shift preferably being below 5°, the gain difference preferably being less than 0.1 dB and said band-pass filter (320; 420; 520) preferably comprising a second order band-pass filter.

5. A circuit arrangement (400) according to any of the claims 1 to 4, wherein said band-pass filter comprises a first serial RC circuit and a second serial RC circuit,

a. a capacitor (423) of said first serial RC circuit being coupled to the first input terminal (411a) of the AC input port (410), a resistor (424) of said first serial RC circuit being coupled to the second input terminal (411b) of the AC input port (410),

b. a capacitor (425) of said second serial RC circuit being coupled to a tap between the capacitor (423) and the resistor (424) of said first serial RC circuit, a resistor (426; 427; 428) of said second serial RC circuit being connected to said first input terminal (411a) of the AC input port (410), each of the filter outputs being connected to a tap between the resistor (426; 427; 428) of the second serial RC circuit or to a tap between said resistor (426; 427; 428) and the capacitor(425) of the second RC circuit.

6. A circuit arrangement (500) according to any of the claims 3 to 5, wherein, the first output signal (571a) of the band-pass filter (520) being defined by its voltage potential in reference to the first input terminal (511a) of the AC input port (510) and the second output signal (571b) of the band-pass filter (520) being defined by its voltage potential in reference to the second input terminal (511b) of the AC input port (510).

7. A circuit arrangement (500) according to any of the claims 3, 4 or 6, wherein said band-pass filter (520) comprises a first serial RC circuit, a second serial RC circuit and a third serial RC circuit,

a. said first serial RC circuit comprising a first capacitor (523a) being coupled with one terminal to the first input terminal (511a) of the AC input port (510), a second capacitor (523b) being coupled with one terminal to the second input terminal (511b) of the AC input port (510) and a first resistor (524) being coupled between the free terminals of said first and second capacitor (523a; 523b),

b. a capacitor (525a) of said second serial RC circuit being coupled to a tap between the resistor (524) and the first capacitor (523a) of said first serial RC circuit, a resistor (526a; 527a) of said second serial RC circuit being connected to said first input terminal (511a) of said AC input port (510), the first filter output (522a) being connected to a tap between the resistor (526a; 527a) of said second serial RC circuit or a tap between the resistor (526a; 527a) and the capacitor (525a) of said second serial RC circuit,

c. a capacitor (525b) of said third serial RC circuit being coupled to a tap between the resistor (524) and the second capacitor (523b) of said first serial RC circuit, a resistor (526b; 527b) of said third serial RC circuit being connected to said second input terminal (511b) of said AC input port (510), the second filter output (522b) being connected to a tap between the resistor (526b; 527b) of said third serial RC circuit or a tap between the resistor (526b; 527b) and the capacitor (525b) of said third serial RC circuit.

8. A circuit arrangement (400; 500) according to any of the claims 1 to 7 wherein the threshold detection circuit (430; 530) comprises a first blocking element (487a; 587a), preferably a diode, being connected between the first voltage input (431a; 531a) and the first input terminal (411a; 511a) of the AC-input port (410; 510), being conducting in the direction from the first input terminal (411a; 511a;) to the first voltage input (431a; 531a) and blocking in the opposite direction.

9. A circuit according to any of the claims 1 to 8, wherein each comparator element (335a; 435a; 535a; 335b; 435b; 535b) provides a hysteresis.

10. A circuit arrangement according to any of claims 1 to 9 wherein each reference voltage is provided by a respective reference voltage circuit (336a; 436a; 536a) which includes an adjustable Zener shunt regulator (584).

11. A circuit arrangement according to any of the claims 1 to 10 where said circuit arrangement comprises a DC supplying circuit (360; 460; 560) for supplying a first DC supply voltage (Vcc1) to the threshold detection circuit.

12. A circuit arrangement (400) according to claim 11, wherein said DC supplying circuit (460)

a. comprises a first DC charging circuit (603a) for generating a first DC supply voltage Vcc1 in reference to the first input terminal (511a) of the AC input port (510) and a capacitive element (604),

b. said DC charging circuit (603a) and said capacitive element (604) being connected in series between the first and second input terminal (311a; 411a; 511a;411b; 511b; 611b) of the AC input port (310; 410; 510; 610),

c. said capacitive element (604) acting as load for limiting the current and voltage.

d. said DC charging circuit comprising a parallel circuit including a capacitor (606a) being charged by the AC line voltage (100) and a voltage limiting element for limiting the DC supply voltage of the DC charging circuit, preferably a Zener diode (605a);

e. said DC charging circuit further comprising a first DC supply voltage output (609a) being connected to a tap between the parallel circuit and the capacitive element for outputting the first DC supply voltage Vcc1,

f. said DC charging circuit further comprising a blocking element, preferably a diode (607a) to prevent the capacitive element from being discharged.

13. A circuit arrangement (500) according to claim 12, wherein said DC supplying (560) circuit comprises a second DC charging circuit (603b), the first charging circuit (603a); the second charging circuit (603b) and the capacitive element (604) are arranged in a mirror symmetrical manner in regard to the first and the second input terminal (511a; 511b) of the AC input port (510) for providing a first DC supply voltage Vcc1 and a second DC supply voltage Vcc2 to the threshold detection circuit (530).

14. A circuit arrangement (300; 400; 500) according to any of the precedent claims, including at least one controllable switch (441a; 441b) for actuating a device or for generating a signal which is used for further processing, wherein exactly one controllable switch (441a; 441b) is assigned to each of the detection outputs (434a; 434b), the controllable switch (441a; 441b) comprising a first and a second terminal and a control input, the control input being connected to respective detection output (434a; 434b) of the threshold detection circuit (430), the first terminal being connected to one of the two input terminals (411a; 411b) of the AC-input port (410) to which the corresponding filter output signal (471a; 471b) is referenced and the second terminal to another one of the two input terminals (411a; 411b) of the AC-input port (410), said controllable switches are always conducting from the first terminal to the second terminal, the controllable switches preferably comprising a MOSFET (441a, 441b) with a source connected to the first terminal of said controllable switch, a drain connected to the second terminal of said controllable switch, a gate connected to the control input of said controllable switch.

15. A circuit arrangement according (400) to any of the precedent claims, **characterized in that** said signal transfer circuit (440) includes in series connection

      a. a serial RC circuit (442a; 442b),
      b. at least one of the controllable switches (441a; 441b),
      c. a decoupling transfer circuit comprising a first LED (443a; 443b) and a diode (446a; 446b) that is arranged antiparallel to the first LED (443a; 443b), said LED (443a; 443b) being conducting in the direction opposite to the direction in which the controllable switch (441a; 441b) is always conducting,
      d. the signal transfer circuit (440) further includes a first light sensitive element (444a; 444b) for receiving light emitted by said first LED (443a; 443b) where the light sensitive element preferably includes a photo transistor.

16. A method for detecting a crossing of a threshold by an AC line voltage (100) of a power network for an electrical device (570) including components, the AC line voltage (100) having a fundamental frequency of 45 Hz to 65 Hz, comprising the steps of

      a. outputting a detection signal if a first voltage threshold is crossed by the AC line voltage (100),
      b. providing a first input voltage by band-pass filtering the AC line voltage (100),
      c. comparing the first input voltage to a reference voltage
      d. generating the detection signal if said first input voltage crosses said reference voltage,
      **characterized by** the steps of
      e. transmitting the detection signal with a galvanically decoupling transfer circuit to a threshold detection logic, and
      f. generating control signals for enabling or disabling components of the electrical device (570) with the threshold detection logic, based on the transmitted detection signal.

## Patentansprüche

1. Eine Schaltungsanordnung (300; 400; 500) für ein elektrisches Gerät (570) mit Komponenten, wobei die Schaltungsanordnung (300; 400; 500) umfasst (i) einen Wechselstromeingangsanschluss (310; 410; 510) zum Anschließen einer Wechselstromleitungsspannung (100) eines Stromnetzes mit einer Fundamentalfrequenz von 45 Hz bis 65 Hz und (ii) eine Schwellenwertdetektionsschaltung (330; 430; 530) mit einem ersten Detektionsausgang (334a; 434a; 534a) zum Ausgeben eines Detektionssignals, wenn ein erster Spannungsschwellenwert von der Wechselstromleitungsspannung (100) überschritten wird, wobei der Wechselstromeingangsanschluss (310; 410; 510) eine erste Eingangsklemme (211a, 311a, 411a, 511a) und eine zweite Eingangsklemme (211b, 311b, 411b, 511b) umfasst und die Schwellenwertdetektionsschaltung (330; 430; 530) einen ersten Spannungseingang (331a; 431a; 531a) und ein erstes Komparatorelement (335a; 435a; 535a) zum Vergleichen einer Spannung am ersten Spannungseingang (331a; 431a; 531a) mit einer Referenzspannung und zum Ausgeben des Detektionssignals am ersten Detektionsausgang (334a; 434a; 534a), wenn die Spannung am ersten Spannungseingang (331a; 431a; 531a) die Referenzspannung überquert, umfasst, wobei die Schaltungsanordnung umfasst (iii) einen Bandpassfilter (320; 420; 520), der zwischen dem Wechselstromeingangsanschluss (310; 410; 510) und dem ersten Spannungseingang (331a; 431a) geschaltet ist, **dadurch gekennzeichnet, dass** die Schaltungsanordnung (300; 400; 500) umfasst (iv) eine galvanisch entkoppelnde Übertragungsschaltung (340; 440; 540), wobei der erste Detektionsausgang (334a; 434a; 534a) mit der galvanisch entkoppelnden Übertragungsschaltung (340; 440, 540) verbunden ist und wobei die galvanisch entkoppelnde Übertragungsschaltung (340; 440; 540) so konfiguriert ist, dass sie das vom ersten Detektionsausgang (334a; 434a; 534a) empfangene Detektionssignal an eine Schwellenwertdetektionslogik (350; 450; 550) überträgt, und dass die Schaltungsanordnung (300; 400; 500) umfasst (v) die Schwellenwertdetektionslogik (350; 450; 550), wobei die Schwellenwertdetektionslogik (350; 450; 550) einen Signaleingang (255a; 255b) umfasst, der mit der galvanisch entkoppelnden Übertragungsschaltung (340; 440; 540) verbunden ist, wobei die Schwellenwertdetektionslogik (550) dazu ausgelegt ist, Steuersignale zum Aktivieren oder Deaktivieren von Komponenten des elektrischen Geräts (570) auf der Grundlage des übertragenen Detektionssignals zu erzeugen, das am Signaleingang (255a, 255b) empfangen wird.

2. Eine Schaltungsanordnung (300; 400; 500) gemäß Anspruch 1, wobei der Bandpassfilter ein erstes Ausgangssignal (371a; 471a; 571a) an einem ersten Filterausgang (322a; 422a; 522a) bereitstellt, wobei das erste Ausgangssignal (371a; 471a; 571a) durch einen ersten Skalierungsfaktor in Bezug auf die Wechselstromleitungsspannung (100) skaliert wird, wobei der erste Spannungseingang (331a; 431a; 531a) mit dem ersten Filterausgang (432a; 422a; 522a) verbunden ist.

3. Eine Schaltungsanordnung (300; 400; 500) gemäß einem der Ansprüche 1 bis 2, wobei der Bandpassfilter (420; 520) einen zweiten Filterausgang umfasst, der durch einen zweiten Skalierungsfaktor in Bezug auf die Wechselstromleitungsspannung (100) skaliert wird, und wobei die Schwellenwertdetektionsschaltung (430; 530) so ausgelegt ist, dass sie ein Überqueren eines zweiten Spannungsschwellenwerts durch die Wechselstromleitungsspannung (100) detektiert, wobei die Schwellenwertdetektionsschaltung (430; 530) einen zweiten Spannungseingang (431b; 531b), der mit dem zweiten Filterausgang (422b; 522b) verbunden ist, einen zweiten Detektionsausgang (434b; 534b) und ein zweites Komparatorelement (435b; 535b) zum Vergleichen einer Spannung am zweiten Spannungseingang entweder mit der Referenzspannung oder mit einer zweiten Referenzspannung und zum Ausgeben eines Detektionssignals am zweiten Detektionsausgang (434b; 534b), wenn die Spannung am zweiten Spannungseingang die Referenzspannung bzw. die zweite Referenzspannung überschreitet umfasst.

4. Eine Schaltungsanordnung (300; 400; 500) gemäß einem der vorhergehenden Ansprüche, wobei ein Durchlassbereich (497) des Bandpassfilters einen Fundamentalfrequenzbereich der Wechselstromleitungsspannung (100) umfasst, und wobei der Bandpassfilter eine Phasenverschiebung des Bandpassfilters im Fundamentalfrequenzbereich von weniger als 45° aufweist und wobei eine Verstärkungsdifferenz in Bezug auf die jeweiligen Skalierungsfaktoren weniger als 0,5 dB beträgt, wobei die Fundamentalfrequenz vorzugsweise zwischen 45 Hz und 65 Hz liegt, die Phasenverschiebung vorzugsweise weniger als 5° beträgt, die Verstärkungsdifferenz vorzugsweise weniger als 0,1 dB beträgt und der Bandpassfilter (320; 420; 520) vorzugsweise ein Bandpassfilter zweiter Ordnung umfasst.

5. Eine Schaltungsanordnung (400) gemäß einem der Ansprüche 1 bis 4, wobei der Bandpassfilter eine erste serielle RC-Schaltung und eine zweite serielle RC-Schaltung umfasst,

   a. wobei ein Kondensator (423) der ersten seriellen RC-Schaltung mit der ersten Eingangsklemme (411a) des Wechselstromeingangsanschlusses (410) gekoppelt ist, wobei ein Widerstand (424) der ersten seriellen RC-Schaltung mit der zweiten Eingangsklemme (411b) des Wechselstromeingangsanschlusses (410) gekoppelt ist, b. wobei ein Kondensator (425) der zweiten seriellen RC-Schaltung mit einem Abgriff zwischen dem Kondensator (423) und dem Widerstand (424) der ersten seriellen RC-Schaltung gekoppelt ist, wobei ein Widerstand (426; 427; 428) der zweiten seriellen RC-Schaltung mit der ersten Eingangsklemme (411a) des Wechselstromeingangsanschlusses (410) verbunden ist, wobei jeder der Filterausgänge verbunden ist mit einem Abgriff zwischen dem Widerstand (426; 427; 428) der zweiten seriellen RC-Schaltung oder mit einem Abgriff zwischen dem Widerstand (426; 427; 428) und dem Kondensator (425) der zweiten RC-Schaltung.

6. Eine Schaltungsanordnung (500) gemäß einem der Ansprüche 3 bis 5, wobei das erste Ausgangssignal (571a) des Bandpassfilters (520) durch sein Spannungspotential in Bezug auf die erste Eingangsklemme (511a) des Wechselstromeingangsanschlusses (510) definiert ist und das zweite Ausgangssignal (571b) des Bandpassfilters (520) durch sein Spannungspotential in Bezug auf die zweite Eingangsklemme (511b) des Wechselstromeingangsanschlusses (510) definiert ist.

7. Eine Schaltungsanordnung (500) gemäß einem der Ansprüche 3, 4 oder 6, wobei der Bandpassfilter (520) eine erste serielle RC-Schaltung, eine zweite serielle RC-Schaltung und eine dritte serielle RC-Schaltung umfasst,

a. wobei die erste serielle RC-Schaltung einen ersten Kondensator (523a) umfasst, der mit einer Klemme an die erste Eingangsklemme (511a) des Wechselstromeingangsanschlusses (510) gekoppelt ist, wobei ein zweiter Kondensator (523b) mit einer Klemme an die zweite Eingangsklemme (511b) des Wechselstromeingangsanschlusses (510) gekoppelt ist und wobei ein erster Widerstand (524) zwischen den freien Klemmen des ersten und des zweiten Kondensators (523a; 523b) gekoppelt ist,
b. wobei ein Kondensator (525a) der zweiten seriellen RC-Schaltung mit einem Abgriff zwischen dem Widerstand (524) und dem ersten Kondensator (523a) der ersten seriellen RC-Schaltung gekoppelt ist, wobei ein Widerstand (526a; 527a) der zweiten seriellen RC-Schaltung mit der ersten Eingangsklemme (511a) des Wechselstromeingangsanschlusses (510) verbunden ist, wobei der erste Filterausgang (522a) verbunden ist mit einem Abgriff zwischen dem Widerstand (526a; 527a) der zweiten seriellen RC-Schaltung oder einem Abgriff zwischen dem Widerstand (526a; 527a) und dem Kondensator (525a) der zweiten seriellen RC-Schaltung,
c. wobei ein Kondensator (525b) der dritten seriellen RC-Schaltung mit einem Abgriff zwischen dem Widerstand (524) und dem zweiten Kondensator (523b) der ersten seriellen RC-Schaltung gekoppelt ist, wobei ein Widerstand (526b; 527b) der dritten seriellen RC-Schaltung mit der zweiten Eingangsklemme (511b) des Wechselstromeingangsanschlusses (510) verbunden ist, wobei der zweite Filterausgang (522b) verbunden ist mit einem Abgriff zwischen dem Widerstand (526b; 527b) der dritten seriellen RC-Schaltung oder einem Abgriff zwischen dem Widerstand (526b; 527b) und dem Kondensator (525b) der dritten seriellen RC-Schaltung.

8. Eine Schaltungsanordnung (400; 500) gemäß einem der Ansprüche 1 bis 7, wobei die Schwellenwertdetektionsschaltung (430; 530) ein erstes Sperrelement (487a; 587a), vorzugsweise eine Diode, umfasst, das zwischen dem ersten Spannungseingang (431a; 531a) und der ersten Eingangsklemme (411a; 511a) des Wechselstromeingangsanschlusses (410; 510) geschaltet ist, in Richtung von der ersten Eingangsklemme (411a; 511a) zum ersten Spannungseingang ( 431a; 531a ) leitend und in der entgegengesetzten Richtung sperrend.

9. Eine Schaltung gemäß einem der Ansprüche 1 bis 8, wobei jedes Komparatorelement (335a; 435a; 535a; 335b; 435b; 535b) eine Hysterese bereitstellt.

10. Eine Schaltungsanordnung gemäß einem der Ansprüche 1 bis 9, wobei jede Referenzspannung von einer jeweiligen Referenzspannungsschaltung (336a; 436a; 536a) bereitgestellt wird, die einen einstellbaren Zener-Shunt-Regler (584) umfasst.

11. Eine Schaltungsanordnung gemäß einem der Ansprüche 1 bis 10, wobei die Schaltungsanordnung eine Gleichstromversorgungsschaltung (360; 460; 560) zum Liefern einer ersten Gleichstromversorgungsspannung (Vcc1) an die Schwellenwertdetektionsschaltung umfasst.

12. Eine Schaltungsanordnung (400) gemäß Anspruch 11, wobei die Gleichstromversorgungsschaltung (460)

a. eine erste Gleichstrom-Ladeschaltung (603a) zum Erzeugen einer ersten Gleichstromversorgungsspannung Vcc1 in Bezug auf die erste Eingangsklemme (511a) des Wechselstromeingangsanschlusses (510) und ein kapazitives Element (604) umfasst,
b. wobei die Gleichstrom-Ladeschaltung (603a) und das kapazitive Element (604) in Reihe zwischen der ersten und der zweiten Eingangsklemme (311a; 411a; 511a; 411b; 511b; 611b) des Wechselstromeingangsanschlusses (310; 410; 510; 610) geschaltet sind,
c. wobei das kapazitive Element (604) als Last zum Begrenzen des Stroms und der Spannung dient,
d. wobei die Gleichstrom-Ladeschaltung eine Parallelschaltung, die einen Kondensator (606a) umfasst, der durch die Wechselstromleitungsspannung (100) geladen wird, und ein Spannungsbegrenzungselement zum Begrenzen der Gleichstromversorgungsspannung der Gleichstrom-Ladeschaltung, vorzugsweise eine Zenerdiode (605a), aufweist;
e. wobei die Gleichstrom-Ladeschaltung ferner einen ersten Gleichstromversorgungsspannungsausgang (609a) umfasst, der mit einem Abgriff zwischen der Parallelschaltung und dem kapazitiven Element verbunden ist, um die erste Gleichstromversorgungsspannung Vcc1 auszugeben,
f. wobei die Gleichstrom-Ladeschaltung ferner ein Sperrelement, vorzugsweise eine Diode (607a), umfasst, um zu verhindern, dass das kapazitive Element entladen wird.

**13.** Eine Schaltungsanordnung (500) gemäß Anspruch 12, wobei die Gleichstromversorgungsschaltung (560) eine zweite Gleichstrom-Ladeschaltung (603b) umfasst, wobei die erste Ladeschaltung (603a), die zweite Ladeschaltung (603b) und das kapazitive Element (604) spiegelbildlich symmetrisch in Bezug auf die erste und die zweite Eingangsklemme (511a; 511b) des Wechselstromeingangsanschlusses (510) angeordnet sind, um eine erste Gleichstromversorgungsspannung Vcc1 und eine zweite Gleichstromversorgungsspannung Vcc2 an die Schwellenwertdetektionsschaltung (530) zu liefern.

**14.** Eine Schaltungsanordnung (300; 400; 500) gemäß einem der vorherigen Ansprüche, die mindestens einen steuerbaren Schalter (441a; 441b) zum Betätigen eines Geräts oder zum Erzeugen eines Signals umfasst, das zur weiteren Verarbeitung verwendet wird, wobei genau ein steuerbarer Schalter (441a; 441b) jedem der Detektionsausgänge (434a; 434b) zugeordnet ist, wobei der steuerbare Schalter eine erste und eine zweite Klemme sowie einen Steuereingang umfasst, wobei der Steuereingang mit dem jeweiligen Detektionsausgang (434a; 434b) der Schwellenwertdetektionsschaltung (430) verbunden ist, wobei die erste Klemme mit einer der beiden Eingangsklemmen (411a; 411b) des Wechselstromeingangsanschlusses (410) verbunden ist, auf die sich das entsprechende Filterausgangssignal (471a; 471b) bezieht, und wobei die zweite Klemme mit einer anderen der beiden Eingangsklemmen (411a; 411b) des Wechselstromeingangsanschlusses (410) verbunden ist, wobei die steuerbaren Schalter immer von der ersten Klemme zur zweiten Klemme leiten, wobei die steuerbaren Schalter vorzugsweise einen MOSFET (441a, 441b) mit einer Source, die mit der ersten Klemme des steuerbaren Schalters verbunden ist, einem Drain, der mit der zweiten Klemme des steuerbaren Schalters verbunden ist, und einem Gate, das mit dem Steuereingang des steuerbaren Schalters verbunden ist, umfassen.

**15.** Eine Schaltungsanordnung gemäß (400) einem der vorherigen Ansprüche, **dadurch gekennzeichnet, dass** die Signalübertragungsschaltung (440) in Reihenschaltung umfasst

 a. eine serielle RC-Schaltung (442a; 442b),
 b. mindestens einen der steuerbaren Schalter (441a; 441b),
 c. eine Entkopplungsübertragungsschaltung, die eine erste LED (443a; 443b) und eine Diode (446a; 446b) umfasst, die antiparallel zur ersten LED (443a; 443b) angeordnet ist, wobei die LED (443a; 443b) in der Richtung leitend ist, die der Richtung entgegengesetzt ist, in der der steuerbare Schalter ( 441a; 441b ) immer leitend ist,
 d. wobei die Signalübertragungsschaltung (440) ferner ein erstes lichtempfindliches Element (444a; 444b) zum Empfangen von Licht umfasst, das von der ersten LED (443a; 443b) emittiert wird, wobei das lichtempfindliche Element vorzugsweise einen Fototransistor umfasst.

**16.** Verfahren zum Detektieren eines Überquerens eines Schwellenwerts durch eine Wechselstromleitungsspannung (100) eines Stromnetzes für ein elektrisches Gerät (570) mit Komponenten, wobei die Wechselstromleitungsspannung (100) eine Fundamentalfrequenz von 45 Hz bis 65 Hz aufweist, mit den folgenden Schritten

 a. Ausgeben eines Detektionssignals, wenn ein erster Spannungsschwellenwert von der Wechselstromleitungsspannung (100) überquert wird,
 b. Bereitstellen einer ersten Eingangsspannung durch Bandpassfilterung der Wechselstromleitungsspannung (100),
 c. Vergleichen der ersten Eingangsspannung mit einer Referenzspannung,
 d. Erzeugen des Detektionssignals, wenn die erste Eingangsspannung die Referenzspannung überquert, **gekennzeichnet durch** die folgenden Schritte
 e. Übertragen des Detektionssignals mit einer galvanisch entkoppelten Übertragungsschaltung an eine Schwellenwertdetektionslogik und
 f. Erzeugen von Steuersignalen zum Aktivieren oder Deaktivieren von Komponenten des elektrischen Geräts (570) mit der Schwellenwertdetektionslogik auf der Grundlage des übertragenen Detektionssignals.

**Revendications**

**1.** Agencement de circuit (300 ; 400 ; 500) pour un dispositif électrique (570) incluant des composants, l'agencement de circuit (300 ; 400 ; 500) comprenant (i) un port d'entrée CA (310 ; 410 ; 510) pour connecter une tension de ligne CA (100) d'un réseau électrique ayant une fréquence fondamentale de 45 Hz à 65 Hz, et (ii) un circuit de détection de seuil (330 ; 430 ; 530) ayant une première sortie de détection (334a ; 434a ; 534a) pour envoyer un signal de détection si un premier seuil de tension est dépassé par la tension de ligne CA (100), où le port d'entrée CA (310 ; 410 ; 510) inclut une première borne d'entrée (211a, 311a, 411a, 511a) et une deuxième borne d'entrée (211b, 311b, 411b, 511b), et le circuit de détection de seuil (330 ; 430 ; 530) inclut une première entrée de tension (331a ; 431a ; 531a) et un premier élément comparateur (335a ; 435a ; 535a) permettant de comparer la tension de la première entrée de tension (331a ; 431a ; 531a) à une tension de référence et d'envoyer le signal de détection à la première sortie de détection (334a ; 434a ; 534a) si ladite tension à la première entrée de tension (331a ; 431a ; 531a) dépasse ladite tension de référence, ledit agencement de circuit inclut (iii) un filtre passe-bande (320 ; 420 ; 520) connecté entre le port d'entrée CA (310 ; 410 ; 510) et ladite première entrée de tension (331a ; 431a), **caractérisé en ce que** l'agencement de circuit (300 ; 400 ; 500) comprend (iv) un circuit de transfert à découplage galvanique (340 ; 440 ; 540), la première sortie de détection (334a ; 434a ; 534a) étant connectée au circuit de transfert à découplage galvanique (340 ; 440, 540) et le circuit de transfert à découplage galvanique (340 ; 440 ; 540) étant configuré pour transmettre le signal de détection reçu de la première sortie de détection (334a ; 434a ; 534a) à une logique de détection de seuil (350 ; 450 ; 550), et **en ce que** l'agencement de circuit (300 ; 400 ; 500) comprend (v) la logique de détection de seuil (350 ; 450 ; 550), la logique de détection de seuil (350 ; 450 ; 550) comprenant une entrée de signal (255a ; 255b) connectée au circuit de transfert à découplage galvanique (340 ; 440 ; 540), où la logique de détection de seuil (550) est adaptée pour générer des signaux de commande de manière à activer ou désactiver des composants du dispositif électrique (570), sur la base du signal de détection transmis reçu à l'entrée de signal (255a, 255b).

2. Agencement de circuit (300 ; 400 ; 500) selon la revendication 1, le filtre passe-bande fournissant un premier signal de sortie (371a ; 471a ; 571a) à une première sortie de filtre (322a ; 422a ; 522a), le premier signal de sortie (371a ; 471a ; 571a) étant mis à l'échelle selon un premier facteur de mise à l'échelle par rapport à la tension de ligne CA (100), où la première entrée de tension (331a ; 431a ; 531a) est connectée à ladite première sortie de filtre (432a ; 422a ; 522a).

3. Agencement de circuit (300 ; 400 ; 500) selon l'une quelconque des revendications 1 et 2, dans lequel ledit filtre passe-bande (420 ; 520) comprend une deuxième sortie de filtre mise à l'échelle selon un deuxième facteur de mise à l'échelle par rapport à la tension de ligne CA (100), et dans lequel le circuit de détection de seuil (430 ; 530) est adapté pour détecter le dépassement d'un deuxième seuil de tension par la tension de ligne CA (100), où le circuit de détection de seuil (430 ; 530) inclut une deuxième entrée de tension (431b ; 531b) connectée à ladite deuxième sortie de filtre (422b ; 522b), une deuxième sortie de détection (434b ; 534b), et un deuxième élément comparateur (435b ; 535b) permettant de comparer une tension à la deuxième entrée de tension soit à ladite tension de référence, soit à une deuxième tension de référence, et d'envoyer un signal de détection à la deuxième sortie de détection (434b ; 534b) si ladite tension à la deuxième entrée de tension dépasse respectivement ladite tension de référence ou ladite deuxième tension de référence.

4. Agencement de circuit (300 ; 400 ; 500) selon l'une quelconque des revendications précédentes, dans lequel une bande passante (497) dudit filtre passe-bande inclut une plage de fréquence fondamentale de la tension de ligne CA (100), et dans lequel le filtre passe-bande présente un déphasage du filtre passe-bande dans la plage de fréquence fondamentale inférieur à 45° et dans lequel une différence de gain par rapport aux facteurs de mise à l'échelle respectifs est inférieure à 0,5 dB, ladite fréquence fondamentale étant de préférence comprise entre 45 Hz et 65 Hz, le déphasage étant de préférence inférieur à 5°, la différence de gain étant de préférence inférieure à 0,1 dB et ledit filtre passe-bande (320 ; 420 ; 520) comprenant de préférence un filtre passe-bande de deuxième ordre.

5. Agencement de circuit (400) selon l'une quelconque des revendications 1 à 4, dans lequel ledit filtre passe-bande comprend un premier circuit RC série et un deuxième circuit RC série,

   a. un condensateur (423) dudit premier circuit RC série étant couplé à la première borne d'entrée (411a) du port d'entrée CA (410), une résistance (424) dudit premier circuit RC série étant couplée à la deuxième borne d'entrée (411b) du port d'entrée CA (410),
   b. un condensateur (425) dudit deuxième circuit RC série étant couplé à une prise située entre le condensateur (423) et la résistance (424) dudit premier circuit RC série, une résistance (426 ; 427 ; 428) dudit deuxième circuit RC série étant connectée à ladite première borne d'entrée (411a) du port d'entrée CA (410), chacune des sorties de filtre étant connectée à une prise sur la résistance (426 ; 427 ; 428) du deuxième circuit RC série ou à une prise située entre ladite résistance (426 ; 427 ; 428) et le condensateur (425) du deuxième circuit RC.

6. Agencement de circuit (500) selon l'une quelconque des revendications 3 à 5, dans lequel le premier signal de sortie (571a) du filtre passe-bande (520) est défini par son potentiel de tension en référence à la première borne d'entrée (511a) du port d'entrée CA (510) et le deuxième signal de sortie (571b) du filtre passe-bande (520) est défini par son potentiel de tension en référence à la deuxième borne d'entrée (511b) du port d'entrée CA (510).

7. Agencement de circuit (500) selon l'une quelconque des revendications 3, 4 ou 6, dans lequel ledit filtre passe-bande (520) comprend un premier circuit RC série, un deuxième circuit RC série et un troisième circuit RC série,

a. ledit premier circuit RC série comprenant un premier condensateur (523a) couplé par une borne à la première borne d'entrée (511a) du port d'entrée CA (510), un deuxième condensateur (523b) couplé par une borne à la deuxième borne d'entrée (511b) du port d'entrée CA (510), et une première résistance (524) couplée entre les bornes libres desdits premier et deuxième condensateurs (523a ; 523b),

b. un condensateur (525a) du deuxième circuit RC série étant couplé à une prise située entre la résistance (524) et le premier condensateur (523a) dudit premier circuit RC série, une résistance (526a ; 527a) dudit deuxième circuit RC série étant connectée à la première borne d'entrée (511a) dudit port d'entrée CA (510), la première sortie de filtre (522a) étant connectée à une prise située à la résistance (526a ; 527a) dudit deuxième circuit RC série ou à une prise située entre la résistance (526a ; 527a) et le condensateur (525a) dudit deuxième circuit RC série,

c. un condensateur (525b) dudit troisième circuit RC série étant couplé à une prise située entre la résistance (524) et le deuxième condensateur (523b) dudit premier circuit RC série, une résistance (526b ; 527b) dudit troisième circuit RC série étant connectée à ladite deuxième borne d'entrée (511b) dudit port d'entrée CA (510), la deuxième sortie de filtre (522b) étant connectée à une prise sur la résistance (526b ; 527b) dudit troisième circuit RC série ou à une prise située entre la résistance (526b ; 527b) et le condensateur (525b) dudit troisième circuit RC série.

8. Agencement de circuit (400 ; 500) selon l'une quelconque des revendications 1 à 7, dans lequel le circuit de détection de seuil (430 ; 530) comprend un premier élément de blocage (487a ; 587a), de préférence une diode, connectée entre la première entrée de tension (431a ; 531a) et la première borne d'entrée (411a ; 511a) du port d'entrée CA (410 ; 510), conductrice dans la direction allant de la première borne d'entrée (411a ; 511a) à la première entrée de tension (431a ; 531a) et bloquante dans la direction opposée.

9. Circuit selon l'une quelconque des revendications 1 à 8, dans lequel chaque élément comparateur (335a ; 435a ; 535a ; 335b ; 435b ; 535b) procure une hystérésis.

10. Agencement de circuit selon l'une quelconque des revendications 1 à 9, dans lequel chaque tension de référence est pourvue par un circuit de tension de référence respectif (336a ; 436a ; 536a) qui inclut un régulateur shunt Zener réglable (584).

11. Agencement de circuit selon l'une quelconque des revendications 1 à 10, dans lequel ledit agencement de circuit comprend un circuit d'alimentation CC (360 ; 460 ; 560) pour fournir une première tension d'alimentation CC (Vcc1) au circuit de détection de seuil.

12. Agencement de circuit (400) selon la revendication 11, dans lequel

a. ledit circuit d'alimentation CC (460) comprend un premier circuit de charge CC (603a) pour générer une première tension d'alimentation CC (Vcc1) en référence à la première borne d'entrée (511a) du port d'entrée CA (510) et un élément capacitif (604),

b. ledit circuit de charge CC (603a) et ledit élément capacitif (604) sont connectés en série entre les première et deuxième bornes d'entrée (311a ; 411a ; 511a ; 411b ; 511b ; 611b) du port d'entrée CA (310 ; 410 ; 510 ; 610),

c. ledit élément capacitif (604) fait office de charge pour limiter le courant et la tension,

d. ledit circuit de charge CC comprend un circuit parallèle incluant un condensateur (606a) chargé par la tension de ligne CA (100) et un élément de limitation de tension pour limiter la tension d'alimentation CC du circuit de charge CC, de préférence une diode Zener (605a) ;

e. ledit circuit de charge CC comprend en outre une première sortie de tension d'alimentation CC (609a) connectée à une prise située entre le circuit parallèle et l'élément capacitif pour délivrer la première tension d'alimentation CC (Vcc1),

f. ledit circuit de charge CC comprend en outre un élément de blocage, de préférence une diode (607a), pour empêcher la décharge de l'élément capacitif.

13. Agencement de circuit (500) selon la revendication 12, dans lequel ledit circuit d'alimentation CC (560) comprend un deuxième circuit de charge CC (603b), et le premier circuit de charge (603a), le deuxième circuit de charge (603b) et l'élément capacitif (604) sont agencés en symétrie miroir par rapport aux première et deuxième bornes d'entrée (511a ; 511b) du port d'entrée CA (510) pour fournir une première tension d'alimentation CC (Vcc1) et une deuxième tension d'alimentation CC (Vcc2) au circuit de détection de seuil (530).

**14.** Agencement de circuit (300 ; 400 ; 500) selon l'une quelconque des revendications précédentes, incluant au moins un interrupteur commandable (441a ; 441b) pour actionner un dispositif ou pour générer un signal utilisé pour un traitement ultérieur, dans lequel un seul interrupteur commandable (441a ; 441b) est attribué à chacune des sorties de détection (434a ; 434b), l'interrupteur commandable (441a ; 441b) comprenant une première borne et une deuxième borne ainsi qu'une entrée de commande, l'entrée de commande étant connectée à la sortie de détection respective (434a ; 434b) du circuit de détection de seuil (430), la première borne étant connectée à l'une des deux bornes d'entrée (411a ; 411b) du port d'entrée CA (410) auquel le signal de sortie de filtre correspondant (471a ; 471b) est référencé, et la deuxième borne étant connectée à l'autre des deux bornes d'entrée (411a ; 411b) du port d'entrée CA (410), lesdits interrupteurs commandables sont toujours conducteurs de la première borne à la deuxième borne, les interrupteurs commandables comprenant de préférence un MOSFET (441a, 441b) avec une source connectée à la première borne dudit interrupteur commandable, un drain connecté à la deuxième borne dudit interrupteur commandable, et une grille connectée à l'entrée de commande dudit interrupteur commandable.

**15.** Agencement de circuit (400) selon l'une quelconque des revendications précédentes, **caractérisé en ce que** ledit circuit de transfert de signal (440) inclut, connectés en série,

    a. un circuit RC série (442a ; 442b),
    b. au moins l'un des interrupteurs commandables (441a ; 441b),
    c. un circuit de transfert de découplage comprenant une première LED (443a ; 443b) et une diode (446a ; 446b) agencée de manière antiparallèle à la première LED (443a ; 443b), ladite LED (443a ; 443b) étant conductrice dans la direction opposée à la direction dans laquelle l'interrupteur commandable (441a ; 441b) est toujours conducteur,
    d. le circuit de transfert de signal (440) incluant en outre un premier élément sensible à la lumière (444a ; 444b) pour recevoir la lumière émise par ladite première LED (443a ; 443b), où l'élément sensible à la lumière inclut de préférence un phototransistor.

**16.** Procédé de détection d'un dépassement de seuil par une tension de ligne CA (100) d'un réseau électrique pour un dispositif électrique (570) incluant des composants, la tension de ligne CA (100) ayant une fréquence fondamentale de 45 Hz à 65 Hz, comprenant les étapes suivantes :

    a. envoi d'un signal de détection si un premier seuil de tension est dépassé par la tension de ligne CA (100),
    b. fourniture d'une première tension d'entrée par un filtrage passe-bande de la tension de ligne CA (100),
    c. comparaison de la première tension d'entrée à une tension de référence,
    d. génération du signal de détection si ladite première tension d'entrée dépasse ladite tension de référence,

**caractérisé par** les étapes suivantes :

    e. transmission du signal de détection avec un circuit de transfert à découplage galvanique à une logique de détection de seuil, et
    f. génération de signaux de commande pour activer ou désactiver des composants du dispositif électrique (570) avec la logique de détection de seuil, sur la base du signal de détection transmis.

111b

1

2

111a

**Fig. 1**

3   4   5   6

224   223   221   270

211b

100

211a

222a

222b

225

**Fig. 2**

**Fig. 3a**

**Fig. 3b**

**Fig. 4b**

**Fig. 4a**

**Fig. 4c**

**Fig. 4d**

**Fig. 4e**

**Fig. 4f**

**Fig. 5a**

**Fig. 5b**

**Fig. 5c**

**Fig. 5d**

**Fig. 5e**

**Fig. 7**

**Fig. 6a**

**Fig. 6b**

**Fig. 6c**

**Fig. 8**

Fig. 9

**EP 3 015 872 B1**

**REFERENCES CITED IN THE DESCRIPTION**

**Patent documents cited in the description**

- DE 19748633 A1
- JP H02292942 B
- JP 5291271 B